# EUROPEAN PATENT SPECIFICATION

(11) **EP 3 605 130 B1**
(45) Date of publication and mention of the grant of the patent: **26.01.2022**
(21) Application number: 19183917.4
(22) Date of filing: 02.07.2019
(51) Int. Cl.: G01R 33/26

(54) **PULSED-BEAM ATOMIC MAGNETOMETER SYSTEM**
ATOMMAGNETOMETERSYSTEM MIT GEPULSTEN STRAHLEN
SYSTÈME DE MAGNÉTOMÈTRE ATOMIQUE À FAISCEAU PULSÉ

(30) Priority: 02.08.2018 US 201816053535
(43) Date of publication of application: 05.02.2020
(73) Proprietor: Northrop Grumman Systems Corporation, Falls Church, VA 22042-4511 (US)
(72) Inventor: BULATOWICZ, Michael D., Falls Church, Virginia 22042-4511 (US); WALKER, Thad G., Falls Church, Virginia 22042-4511 (US); LARSEN, Michael S., Falls Church, Virginia 22042-4511 (US)
(74) Representative: AWA Sweden AB

(56) References cited:
- EP-A1- 3 410 142
- US-A1- 2011 193 555
- US-A1- 2016 061 913
- PUSTELNY S. ET AL.: "All-optical atomic magnetometers based on nonlinear magneto-optical rotation with amplitude modulated light", PROCEEDINGS OF THE SPIE - THE INTERNATIONAL SOCIETY FOR OPTICAL ENGINEERING, 14TH INTERNATIONAL SCHOOL ON QUANTUM ELECTRONICS: LASER PHYSICS AND APPLICATIONS, PO BOX 10 BELLINGHAM WA 98227-0010 USA, 2007, pages 660404-1-660404-8, XP040241875,
- HOVDE C. ET AL.: "Sensitive optical atomic magnetometer based on nonlinear magneto-optical rotation", PROCEEDINGS OF THE SPIE - THE INTERNATIONAL SOCIETY FOR OPTICAL ENGINEERING, UNATTENDED GROUND, SEA, AND AIR SENSOR TECHNOLOGIES AND APPLICATIONS, XII, 5 April 2010 (2010-04-05), pages 769313-1-769313-1, XP040522954,
- Z. D. GRUJIC ET AL: "Atomic magnetic resonance induced by amplitude-, frequency-, or polarization-modulated light", PHYSICAL REVIEW A (ATOMIC, MOLECULAR, AND OPTICAL PHYSICS), vol. 88, no. 1, July 2013 (2013-07), XP055513476, USA ISSN: 1050-2947, DOI: 10.1103/PhysRevA.88.012508

## Description

### TECHNICAL FIELD

This disclosure relates generally to sensor systems, and more specifically to a pulsed-beam atomic magnetometer.

### BACKGROUND

Magnetometer systems, such as nuclear magnetic resonance (NMR) magnetometers and/or electron paramagnetic resonance (EPR) magnetometers, can include a cell that contains one or more alkali metal vapors, such as rubidium or cesium, which can exhibit precession characteristics that can be a function of an external magnetic field. Thus, the magnetometer system can be configured to detect the external magnetic field based on the precession characteristics of the alkali metal vapor(s). Typical magnetometer systems that implement detection of the external magnetic field in three vector axes implement a combination of multiple single-axis or dual-axis vector systems. Such magnetometer systems can typically exhibit sensitivities to dynamics or system misalignments when attempting to determine a whole field scalar measurement, which can result in inaccuracy. Thus, when high sensitivity and stability may be required in a dynamic environment, whole field scalar magnetometer systems are often implemented.

< >

### SUMMARY

A first aspect of the invention concerns a magnetometer in accordance with claim 1. <US 2016/061913 A1 discloses an optically pumped magnetometer including a cell containing alkali metal atoms, a pump beam optical system providing circularly polarized pump beams and a probe beam optical system providing a linearly polarized probe beam, the magnetometer detecting magnetic field intensity of different locations of the cell.>

Another aspect of the invention concerns a method for measuring an external magnetic field via a magnetometer system. The method is defined in claim 9.

### BRIEF DESCRIPTION OF THE DRAWINGS

FIG. 1 illustrates an example of a magnetometer system.
FIG. 2 illustrates an example diagram of an external magnetic field through a sensor cell.
FIG. 3 illustrates an example diagram of interrogation of a sensor cell.
FIG. 4 illustrates another example diagram of an external magnetic field through a sensor cell.
FIG. 5 illustrates an example of a timing diagram.
FIG. 6 illustrates an example of a magnetometer system outside the scope of the present invention.
FIG. 7 illustrates an example of a method for measuring an external magnetic field.
FIG. 8 illustrates yet another example of a magnetometer system.
FIG. 9 illustrates yet another example of a magnetometer system.
FIG. 10 illustrates an example of a magnetometer system in accordance with the current invention.

### DETAILED DESCRIPTION

This disclosure relates generally to sensor systems, and more specifically to a pulsed-beam atomic magnetometer. The magnetometer system can be configured as a Synchronous Light-pulse Atomic Magnetometer (SLAM) system that includes a concurrent pump/pulse beam pumping and interrogation methodology, such as similar to Bell-Bloom all-optical magnetometry. The magnetometer system includes a laser system that includes at least one pump laser and at least one probe laser configured to generate a respective at least one optical pump beam and a respective at least one optical probe beam. As an example, the pump and optical probe beam(s) can be combined via an optical combiner (e.g., a 2x2 optical combiner) to provide the pump and optical probe beam(s) in a collinear manner. The pump and optical probe beam(s) are provided through a sensor cell that includes an alkali metal vapor. The alkali metal vapor can precess in response to an external magnetic field based on alignment of the net magnetic moments of the alkali metal vapor in the cell in response to the circularly-polarized optical pump beam. As a result of the precession, the linearly-polarized optical probe beam can experience a Faraday rotation as it passes through the sensor cell, with the Faraday rotation being based on the instantaneous orientation of the net magnetic moments of the alkali metal vapor as the alkali metal vapor precesses. Therefore, detection beam(s) corresponding to the optical probe beam(s) exiting the sensor cell can be monitored to monitor the precession of the alkali metal vapor.

As an example, the monitored precession of the alkali metal vapor can be provided as feedback to a timing controller to generate a timing signal. The timing signal can thus be provided to the laser system to provide a timing reference as to when to provide the pulsed optical pump beam and optical probe beam through the sensor cell. For example, the laser system can provide an optical pump beam pulse through the sensor cell in response to the timing signal to pump the alkali metal vapor once each period of the precession (e.g., when the magnetic moments are aligned approximately parallel with the optical pump beam axis). As another example, the laser system can provide an optical probe beam pulse through the sensor cell in response to the timing signal when the magnetic moments of the alkali metal vapor are approximately parallel and anti-parallel with the optical probe beam axis to calibrate the magnetometer system. Furthermore, the laser system can provide an optical probe beam pulse through the sensor cell in response to the timing signal when the magnetic moments of the alkali metal vapor are approximately orthogonal with the optical probe beam axis to monitor the amplitude and direction of the external magnetic field, as indicated by the Faraday rotation of the linear polarization.

Furthermore, the sensor cell can include three distinct measurement zones through which the optical pump beam and optical probe beam can be provided. The first measurement zone can be through an approximate center of the sensor cell, such that the timing signal can be generated based on the respective detection beam that is provided from the first measurement zone. The detection beam provided from the first measurement zone can also determine a scalar amplitude and direction of the external magnetic field. In addition, the second and third measurement zones can be arranged at regions of substantially opposite ends of the sensor cell. As a result, a second detection beam corresponding to the optical probe beam exiting the sensor cell through the second measurement zone and a third detection beam corresponding to the optical probe beam exiting the sensor cell through the third measurement zone can be implemented to determine a magnetic field gradient of the external magnetic field based on a differential measurement of the magnetic field through each of the second and third measurement zones.

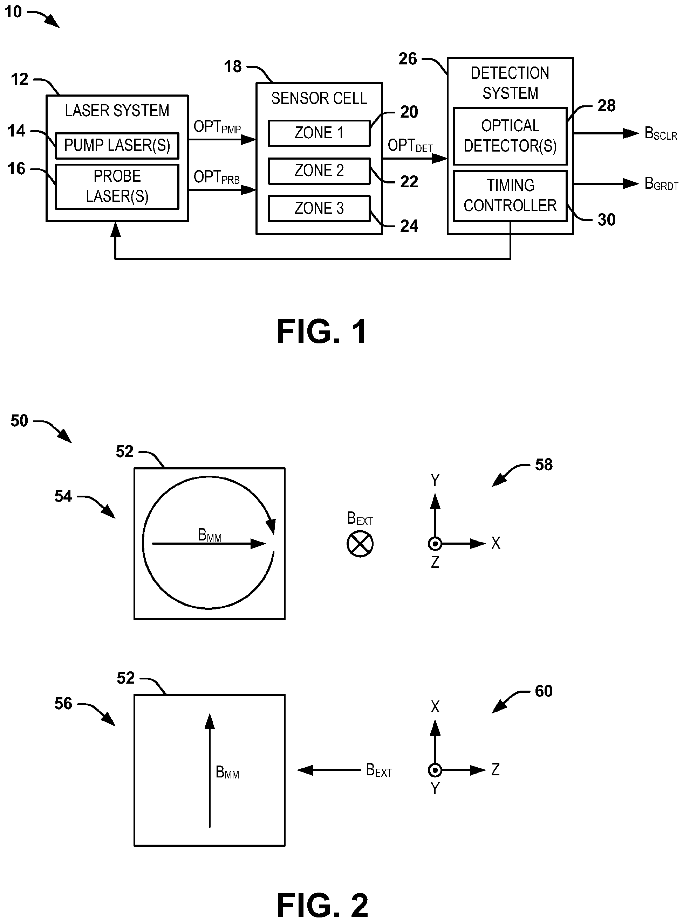

FIG. 1 illustrates an example of a magnetometer system 10. The magnetometer system 10 can be implemented in any of a variety of applications to measure a magnetic field, such as navigation. For example, the magnetometer system 10 can be implemented in an inertial navigation system (INS) for an aircraft or a spacecraft to assist with real-time navigation or location determination.

The magnetometer system 10 includes a laser system 12 that includes at least one pump laser 14 and at least one probe laser 16. The pump laser(s) 14 are each configured to generate a respective optical pump beam OPT_{PMP}, and the probe laser(s) 16 are each configured to generate a respective optical probe beam OPT_{PRB}. The optical pump beam(s) OPT_{PMP} and the optical probe beam(s) OPT_{PRB} are each provided through a sensor cell 18 that includes an alkali metal vapor disposed therein. In the example of FIG. 1, the sensor cell 18 includes a first measurement zone 20 ("ZONE 1"), a second measurement zone 22 ("ZONE 2"), and a third measurement zone 24 ("ZONE 3") that can each correspond to three-dimensional spatial regions within the volume of the sensor cell 18. As an example, the first measurement zone 20 can be arranged approximately centrally along a length of the sensor cell 18, and the second and third measurement zones 22 and 24 can be arranged at opposing ends of the sensor cell 18. As described in greater detail herein, the first, second, and third measurement zones 20, 22, and 24 can be implemented for calibration of the magnetometer system 10, for determining the amplitude and direction of an external magnetic field, for determining a magnetic field gradient associated with the external magnetometer, and for feedback to generate a timing signal associated with the precession of the alkali metal vapor.

The optical pump beam OPT_{PMP} can be provided through the sensor cell 18 to facilitate precession of the alkali metal vapor in response to the external magnetic field. As an example, the optical pump beam OPT_{PMP} can be circularly-polarized, such that the angular momentum of the photons of the optical pump beam OPT_{PMP} can be absorbed by the alkali metal vapor (e.g., based on the wavelength of the optical pump beam OPT_{PMP}). Therefore, the optical pump beam OPT_{PMP} can align the magnetic moment of the alkali metal vapor in an approximately parallel manner with respect to the optical pump beam OPT_{PMP}. Therefore, the alkali metal vapor can precess about the external magnetic field based on the alignment of the magnetic moment of the alkali metal vapor.

FIG. 2 illustrates an example diagram 50 of an external magnetic field B_{EXT} through a sensor cell 52. In the example of FIG. 2, the sensor cell is demonstrated in a first view 54 and a second view 56 that are orthogonal with respect to each other. Particularly, the first view 54 is demonstrated from a view along the Z-axis based on Cartesian coordinate system 58, and the second view 56 is demonstrated from a view along the Y-axis based on Cartesian coordinate system 60. The sensor cell 52 can correspond to the sensor cell 18 in the example of FIG. 1. Therefore, reference is to be made to the example of FIG. 1 in the following description of the example of FIG. 2.

In the example of FIG. 2, an external magnetic field B_{EXT} is demonstrated as being provided orthogonally through the sensor cell 52 in the -Z direction. The sensor cell 52 is also demonstrated as including the alkali metal vapor arranged as having a magnetic moment vector B_{MM} that extends along the X-axis. The magnetic moment vector B_{MM} can correspond to a parallel arrangement of the magnetic moment of the alkali metal vapor in response to being pumped by the optical pump beam OPT_{PMP}. As an example, the optical pump beam OPT_{PMP} can be periodically provided in a pulsed manner to periodically align the magnetic moment vector B_{MM} parallel (e.g., collinear and in the same direction) with the optical pump beam OPT_{PMP}.

In response to the external magnetic field B_{EXT} through the sensor cell 52, the magnetic moment of the alkali metal vapor can precess about the external magnetic field B_{EXT}. In the example of FIG. 2, because the external magnetic field B_{EXT} is provided orthogonally through the sensor cell 52, and thus orthogonally with respect to the magnetic moment vector B_{MM}, the magnetic moment vector B_{MM} can precess clockwise in the XY-plane, and thus orthogonally with respect to the external magnetic field B_{EXT}. The amplitude of the external magnetic field B_{EXT} can determine the frequency of precession of the magnetic moment vector B_{MM}. In addition, as described in greater detail herein, the angle of the external magnetic field B_{EXT} with respect to the angle of the magnetic moment vector B_{MM} can affect the angle of the magnetic moment vector B_{MM} during a period of precession. The angle of the magnetic moment vector B_{MM} can thus be detected by the magnetometer system, as described in greater detail herein, and can be indicative of the angle of the external magnetic field B_{EXT}.

Referring back to the example of FIG. 1, the magnetometer system 10 can also include a detection system 26. The detection system 26 is configured to monitor at least one detection beam OPT_{DET} that is provided from the sensor cell 18. As an example, the detection beam(s) OPT_{DET} can correspond to the optical probe beam OPT_{PRB} being provided through at least one of the respective measurement zones 20, 22, and 24 and exiting the sensor cell 18. As described previously, the optical probe beam OPT_{PRB} can be provided as linearly-polarized. Therefore, based on the precession of the magnetic moment vector B_{MM} of the alkali metal vapor, the optical probe beam OPT_{PRB} can experience Faraday rotation, such that the respective detection beam(s) OPT_{DET} can exhibit the Faraday rotation that can be indicative of the precession of the alkali metal vapor based on the external magnetic field B_{EXT}.

In the example of FIG. 1, the detection system 26 includes at least one optical detector 28 that is configured to detect the Faraday rotation of the respective detection beam(s) OPT_{DET} to monitor the precession of the alkali metal vapor in response to the external magnetic field B_{EXT}. As an example, the optical detector(s) 28 can be configured as a polarization beamsplitter and set of photodetectors (e.g., photodiodes) that can measure a relative Faraday rotation of the detection beam(s) OPT_{DET}. Therefore, based on the measured Faraday rotation of the detection beam(s) OPT_{DET}, the detection system 26 can calculate an amplitude and direction of the external magnetic field B_{EXT}, as described in greater detail herein. In the example of FIG. 1, the detection system 26 is demonstrated as calculating a scalar amplitude and direction of the external magnetic field B_{EXT}, demonstrated as a signal B_{SCLR}, and as calculating a magnetic field gradient of the external magnetic field B_{EXT}, demonstrated as a signal B_{GRDT}.

In the example of FIG. 1, the detection system 26 also includes a timing controller 30. As described previously, the laser system 12 can provide the optical pump beam OPT_{PMP} via the pump laser 14 in a pulsed manner, and can likewise provide the optical probe beam OPT_{PRB} via the probe laser 16 in a pulsed manner. The laser system 12 can provide the pulses of the optical pump beam OPT_{PMP} and the optical probe beam OPT_{PRB} in response to a timing signal TMR that is generated by the timing controller 30 in response to the detection beam(s) OPT_{DET}. For example, the timing signal TMR can correspond to the period of the precession of the alkali metal vapor, such that the timing signal TMR can provide an indication to the laser system 12 as to the time to activate the pump laser(s) 14 to provide the pulse(s) of the optical pump beam OPT_{PMP} and as to the time to activate the probe laser(s) 16 to provide the pulse(s) of the optical probe beam OPT_{PRB}.

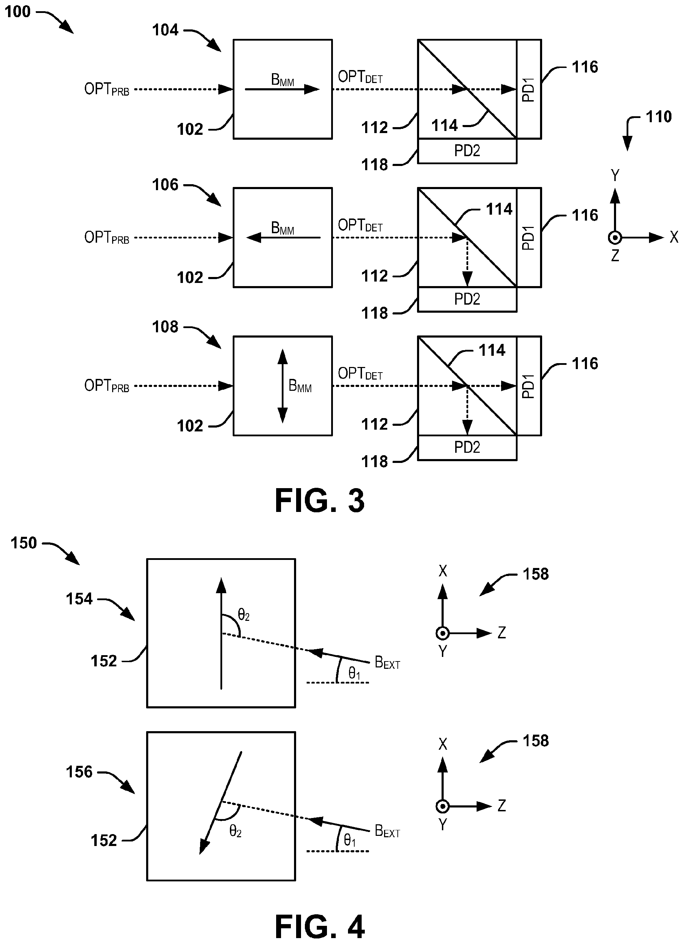

FIG. 3 illustrates an example diagram 100 of interrogation of a sensor cell 102. In the example of FIG. 3, the diagram 100 includes three separate states of the sensor cell 102, demonstrated as a first state 104, a second state 106, and a third state 108. The sensor cell 102 can correspond to the sensor cell 18 in the example of FIG. 1, and the sensor cell 52 in the example of FIG. 2. As an example, the sensor cell 102 can correspond to a given one of the measurement zones 20, 22, and 24 in the sensor cell 18 demonstrated in the example of FIG. 1. Therefore, reference is to be made to the example of FIGS. 1 and 2 in the following description of the example of FIG. 3.

Each of the states 104, 106, and 108 of the sensor cell 102 correspond to separate respective orientations of the magnetic moment vector B_{MM} of the alkali metal vapor during a portion of the precession of the alkali metal vapor in response to the external magnetic field B_{EXT} (not shown in the example of FIG. 3). The first state 104 demonstrates the magnetic moment vector B_{MM} extending in the +X direction based on the Cartesian coordinate system 110, which can correspond to a direction parallel to the optical probe beam OPT_{PRB}. As an example, the optical probe beam OPT_{PRB} and the optical pump beam OPT_{PMP} can be collinear, such that the first state 104 can demonstrate the magnetic moment vector B_{MM} extending parallel with both the optical probe beam OPT_{PRB} and the optical pump beam OPT_{PMP}. As an example, the first state 104 can correspond to a beginning of a precession period of the magnetic moment vector B_{MM}, such that the timing signal TMR can command the laser system 12 to provide a pulse of the optical pump beam OPT_{PMP} via the pump laser 14 to align the alkali metal vapor to form the magnetic moment vector B_{MM}.

In the first state 104, the optical probe beam OPT_{PRB} is demonstrated as being provided through the sensor cell 102 to provide a detection beam OPT_{DET} exiting the sensor cell 102 and being provided to an optical detector 112. As an example, the optical detector 112 can correspond to an optical detector 28 in the example of FIG. 1. The optical detector 112 includes a polarization beamsplitter 114, a first photodetector ("PD1") 116, and a second photodetector ("PD2") 118. In the example of FIG. 3, the detection beam OPT_{DET} can exhibit a substantial maximum Faraday rotation in a first direction about the magnetic moment vector B_{MM} based on the optical probe beam OPT_{PRB} being provided through the sensor cell 102 parallel with the magnetic moment vector B_{MM}. As a result, the detection beam OPT_{DET} can pass preferentially through the polarization beamsplitter 114 to the first photodetector 116. As a result, the detection system 26 in the example of FIG. 1 can identify an approximate magnitude of the magnetic moment vector B_{MM} at the beginning of a precession period of the precession of the alkali metal vapor. For example, the timing signal TMR can command the laser system 12 to provide a calibration pulse of the optical probe beam OPT_{PRB} via the probe laser 16 to determine an approximate magnitude of the magnetic moment vector B_{MM} and to determine if the magnetic moment vector B_{MM} is parallel with the optical probe beam OPT_{PRB}.

The second state 106 demonstrates the magnetic moment vector B_{MM} extending in the -X direction based on the Cartesian coordinate system 110, which can correspond to a direction anti-parallel to the optical probe beam OPT_{PRB}. As an example, the second state 106 can correspond to an approximately 180° phase of the precession period of the magnetic moment vector B_{MM}. In the second state 106, the optical probe beam OPT_{PRB} is demonstrated as being provided through the sensor cell 102 to provide a detection beam OPT_{DET} exiting the sensor cell 102 and being provided to the optical detector 112. In the example of FIG. 3, the detection beam OPT_{DET} can exhibit an approximate maximum Faraday rotation in a second direction opposite the first direction based on the optical probe beam OPT_{PRB} being provided through the sensor cell 102 anti-parallel with the magnetic moment vector B_{MM}. As a result, the detection beam OPT_{DET} can be preferentially reflected by the polarization beamsplitter 114 to the second photodetector 118. As a result, the detection system 26 in the example of FIG. 1 can identify that the magnetic moment vector B_{MM} is at the time during the precession period of the precession of the alkali metal vapor that the magnetic moment vector B_{MM} is anti-parallel with respect to the optical probe beam OPT_{PRB} and can determine an approximate magnitude of the magnetic moment vector B_{MM} at the 180° phase in the precession cycle. For example, the timing signal TMR can command the laser system 12 to provide a calibration pulse of the optical probe beam OPT_{PRB} via the probe laser 16 to determine if the magnetic moment vector B_{MM} is anti-parallel with the optical probe beam OPT_{PRB} and measure its magnitude.

The third state 108 demonstrates the magnetic moment vector B_{MM} extending in either the +Y direction or -Y direction based on the Cartesian coordinate system 110, which can correspond to directions orthogonal to the optical probe beam OPT_{PRB}. As an example, the third state 106 can correspond to either approximately 90° phase or 270° phase of the precession period of the magnetic moment vector B_{MM}. In the third state 108, the optical probe beam OPT_{PRB} is demonstrated as being provided through the sensor cell 102 to provide a detection beam OPT_{DET} exiting the sensor cell 102 and being provided to the optical detector 112. In the example of FIG. 3, the detection beam OPT_{DET} can exhibit an approximate zero Faraday rotation based on the optical probe beam OPT_{PRB} being provided through the sensor cell 102 orthogonally with the magnetic moment vector B_{MM}. As a result, the detection beam OPT_{DET} can be partially (e.g., half) reflected by the polarization beamsplitter 114, and thus provided approximately equally to each of the first photodetector 116 and the second photodetector 118. As a result, the detection system 26 in the example of FIG. 1 can identify that the magnetic moment vector B_{MM} is at the time during the precession period of the precession of the alkali metal vapor that the magnetic moment vector B_{MM} is approximately orthogonal with respect to the optical probe beam OPT_{PRB}. For example, the timing signal TMR can command the laser system 12 to provide a measurement pulse of the optical probe beam OPT_{PRB} via the probe laser 16 to determine if the magnetic moment vector B_{MM} is orthogonal to the optical probe beam OPT_{PRB}.

Therefore, based on the states 104, 106, and 108 demonstrated in the example of FIG. 3, the detection system 26 can monitor the detection beam OPT_{DET} at the appropriate times in a feedback manner based on the timing signal TMR to monitor the precession of the alkali metal vapor, and thus to determine the amplitude and direction of the external magnetic field B_{EXT}. As an example, upon initialization of the magnetometer system 10, the detection system 26 can command the laser system 12 to provide the optical probe beam OPT_{PRB} substantially continuously through the first measurement zone 20 of the sensor cell 18 to determine an initial precession of the alkali metal vapor in the sensor cell 18 in response to the external magnetic field B_{EXT}. For example, the detection system 26 can generate a waveform based on a differential measurement between the first photodetector 116 and the second photodetector 118 to determine an initial frequency of the precession of the external magnetic field B_{EXT}, which can correspond to the amplitude of the external magnetic field B_{EXT}. In addition, the initial precession can also indicate the portions of the precession that correspond to the anti-parallel orientation of the magnetic moment of the alkali metal vapor, such as demonstrated in the second state 106 in the example of FIG. 3, and the portions of the precession that correspond to the orthogonal orientations of the magnetic moment of the alkali metal vapor, such as demonstrated in the third state 108 in the example of FIG. 3. The relative offset of the timing of the second and third states 106 and 108, respectively, can be indicative of the angle of the external magnetic field B_{EXT}, as described in greater detail herein.

In response to determining the initial precession of the alkali metal vapor, the timing controller 30 can generate the timing signal TMR based on the initial precession of the alkali metal vapor. The detection system 26 can thus cease the substantially constant application of the optical probe beam OPT_{PRB}, such that the laser system 12 can provide the optical pump beam OPT_{PMP} pulses via the pump laser 14 and the optical probe beam OPT_{PRB} pulses via the probe laser 16 based on the timing signal TMR. As a result, the detection system 26 can monitor the detection beam OPT_{DET} from the first measurement zone 20 to monitor the precession of the alkali metal vapor based on observing the detection beam OPT_{DET} in the third state 108. As an example, in response to detecting an uneven amplitude of the detection beam OPT_{DET} with respect to the first and second photodetectors 116 and 118, the detection system 26 can identify that the external magnetic field B_{EXT} has changed in amplitude and/or direction based on the precession of the alkali metal vapor being misaligned from the application of the optical probe beam OPT_{PRB} pulse in response to the timing signal TMR. Therefore, the detection system 26 can identify the change in the external magnetic field B_{EXT} (e.g., providing the measured magnetic field B_{SCLR} appropriately), and the timing controller 30 can change the timing signal TMR accordingly.

As described previously, the first state 104 can correspond to the alignment of the magnetic moment vector B_{MM} in response to the optical pump beam OPT_{PMP} pulse. However, as also described previously, the precession of the magnetic moment of the alkali metal vapor is provided about the direction of the external magnetic field B_{EXT}. Therefore, the precession of the alkali metal vapor may not necessarily be planar with respect to the XY-plane, as demonstrated in the examples of FIGS. 2 and 3. Therefore, the relative timing of the second and third states 106 and 108 may not necessarily correspond to 180° of the precession period for the second state and 90° and 270° of the precession period for the third state 108.

FIG. 4 illustrates another example diagram 150 of an external magnetic field B_{EXT} through a sensor cell 152. In the example of FIG. 4, the sensor cell is demonstrated in a first view 154 and a second view 156 that are orthogonal with respect to each other. Particularly, each of the first view 154 and second view 156 are demonstrated from a view along the Y-axis based on Cartesian coordinate system 158. The sensor cell 152 can correspond to the sensor cell 18 in the example of FIG. 1. Therefore, reference is to be made to the example of FIGS. 1-3 in the following description of the example of FIG. 4.

The sensor cell 152 is demonstrated as including the alkali metal vapor arranged as having a magnetic moment vector B_{MM} that extends along the X-axis. Similar to as described previously, the magnetic moment vector B_{MM} can correspond to a parallel arrangement of the magnetic moment of the alkali metal vapor in response to being pumped by the optical pump beam OPT_{PMP}. As an example, the optical pump beam OPT_{PMP} can be periodically provided in a pulsed manner to periodically align the magnetic moment vector B_{MM} parallel (e.g., collinear and in the same direction) with the optical pump beam OPT_{PMP}. In the example of FIG. 4, an external magnetic field B_{EXT} is demonstrated as being provided through the sensor cell 152 at an angle θ₁ relative to the -Z axis, and thus provides an angle of θ₂ relative to the magnetic moment vector B_{MM}, wherein θ₂ minus θ₁ is equal to approximately 90°.

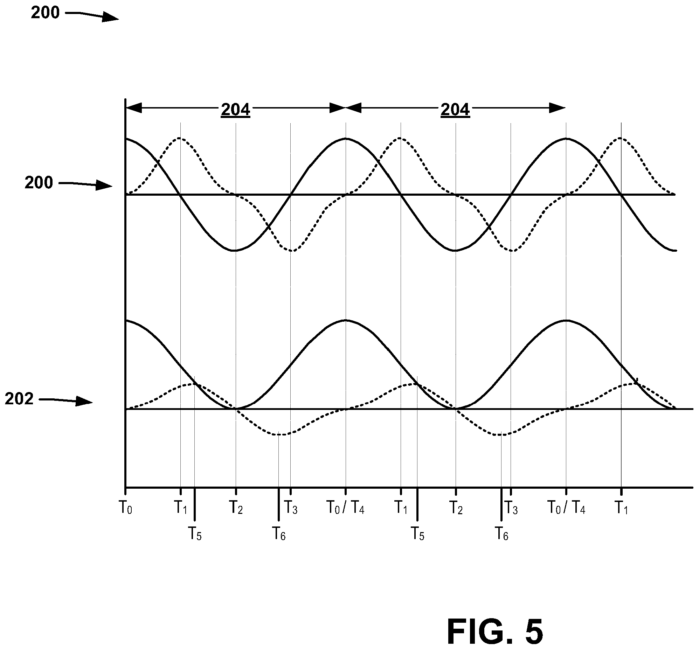

In response to the external magnetic field B_{EXT} through the sensor cell 152, the magnetic moment of the alkali metal vapor can precess about the external magnetic field B_{EXT}. In the example of FIG. 4, because the external magnetic field B_{EXT} is provided at the angle θ₁ through the sensor cell 152, the magnetic moment vector B_{MM} can precess at the angle θ₂ about the external magnetic field B_{EXT}. In the example of FIG. 2, the second view 156 can thus demonstrate the magnetic moment vector B_{MM} at a portion of the precession that is opposite the portion of the precession demonstrated in the first view 154 (e.g., at 180° out-of-phase during the precession of the magnetic moment vector B_{MM}). In addition, it is to be understood that the magnetic moment vector B_{MM} will not be collinear with the Y-axis during the 90° and 270° phases of the precession of the alkali metal vapor, but will instead be angularly offset from the Y-axis based on the angle θ₁ of the external magnetic field B_{EXT} relative to the Z-axis. As a result, the measured amplitude of the external magnetic field B_{EXT} will not be symmetrical about zero at each 180° phase interval of the precession period of the alkali metal vapor, as described in greater detail herein with reference to FIG. 5.

FIG. 5 illustrates an example of timing diagrams 200 and 202. The timing diagram 200 can correspond to a precession of the alkali metal vapor based on the external magnetic field B_{EXT} being provided orthogonally with respect to the axis of the optical probe beam OPT_{PRB}, and thus along the -Z axis, as demonstrated in the example of FIG. 2. The timing diagram 200 demonstrates the spin projection of the magnetic moment vector B_{MM} along the optical probe beam OPT_{PRB} as a solid line. The timing diagram 200 further demonstrates the relative sensitivity of measurement of gradients in the amplitude of the external magnetic field B_{EXT} as a function of the direction of the magnetic moment vector B_{MM}, and thus based on the optical detector(s) 28 as a function of the Faraday rotation of the detection beam(s) OPT_{DET}, as a dotted line.

Similarly, the timing diagram 202 can correspond to a precession of the alkali metal vapor based on the external magnetic field B_{EXT} being provided at an angle θ₁=45° with respect to the axis of the optical pump beam OPT_{PMP}, and thus such that the angle θ₂=45°, similar to as demonstrated in the example of FIG. 4 (whereas the angles θ₁ and θ₂ are not necessarily illustrated to scale). The timing diagram 202 demonstrates the spin projection of the magnetic moment vector B_{MM} along the optical probe beam OPT_{PRB} as a solid line. The timing diagram 202 further demonstrates the relative sensitivity of measurement of gradients in the amplitude of the external magnetic field B_{EXT} as a function of the magnetic moment vector B_{MM}, and thus based on the optical detector(s) 28 as a function of the Faraday rotation of the detection beam(s) OPT_{DET}, as a dotted line.

In the example of FIG. 5, the periods of the precession of the magnetic moment vector B_{MM} are demonstrated at intervals 204, beginning at a time T₀. Particularly, at a time T₀ of each precession period, the laser system 12 can provide a pulse of the optical pump beam OPT_{PMP} to align the magnetic moment vector B_{MM} along the axis of the optical pump beam OPT_{PMP}. Subsequently, the magnetic moment vector B_{MM} precesses about the external magnetic field B_{EXT}. A time T₁ corresponds to 90° of the precession period, a time T₂ corresponds to 180° of the precession period, a time T₃ corresponds to 270° of the precession period, and a time T₄ corresponds to completion of the precession period and the beginning of a next precession period. Thus, at the time T₄, the laser system 12 can again provide a pulse of the optical pump beam OPT_{PMP} to align the magnetic moment vector B_{MM} along the axis of the optical pump beam OPT_{PMP}.

In addition, similar to as described previously, the laser system 12 can provide pulses of the optical probe beam OPT_{PRB} to calibrate the magnetometer system 10. As an example, the laser system 12 can provide pulses of the optical probe beam OPT_{PRB} at the time T₀ and the time T₂, and thus at 180° opposite phases of the precession of the alkali metal vapor, to calibrate the magnetometer system 10. As an example, the calibration pulses of the optical probe beam OPT_{PRB} can correspond to the timing of the first state 104 and the second state 106 demonstrated in the example of FIG. 3.

For example, the calibration pulses of the optical probe beam OPT_{PRB} can be substantially reduced in optical energy relative to interrogation pulses intended to measure the amplitude of the external magnetic field B_{EXT} and gradients therein, as described in greater detail herein. Therefore, in response to the calibration pulse provided at the time T₀/ T₄, the optical detector(s) 112 can determine that the optical energy of the detection beam OPT_{DET} is provided preferentially on either the first photodetector 116 or the second photodetector 118. Similarly, in response to the calibration pulse provided at the time T₂, the optical detector(s) 112 can determine that the optical energy of the detection beam OPT_{DET} is provided preferentially on the other of the first photodetector 116 and the second photodetector 118. The laser system 12 can also provide measurement pulses of the optical probe beam OPT_{PRB} at times T₁ and T₃ in the example of timing diagram 200 or times T₂, T₅ and T₆ in the example of timing diagram 202. These measurement pulses can be of a substantially higher magnitude than the optical probe beam OPT_{PRB} pulses provided during times T₀/T₄ and T₂. If the detection system 26 determines that the optical energy of detection beam OPT_{DET} is shared unequally between the first and second photodetectors 116 and 118 during a measurement pulse of the optical probe beam OPT_{PRB} at time T₁ or T₃ in the example of timing diagram 200 or T₂ in the example of timing diagram 202, the timing controller 28 can adjust the timing signal TMR accordingly in a feedback manner. Changes to the sharing of optical energy of the detection beam OPT_{DET} on the photodetectors 116 and 118 can indicate a change in amplitude of the external magnetic field B_{EXT}, given that the amplitude of the external magnetic field B_{EXT} affects the frequency of the precession of the alkali metal vapor, and thus the length of the precession period of the alkali metal vapor.

The timing diagram 200 thus demonstrates a sinusoidal spin projection of the magnetic moment vector B_{MM} about zero based on the planar precession of the magnetic moment vector B_{MM}, as demonstrated in the example of FIG. 2. Additionally, because the precession of the magnetic moment vector B_{MM} is planar in the example of FIG. 2 based on the external magnetic field B_{EXT} being orthogonal to the axis of the optical probe beam OPT_{PRB}, the external magnetic field B_{EXT}, as observed by the optical detector(s) 28 via the detection beam(s) OPT_{DET}, is symmetrical about zero at each 180° interval of the period of the precession. The laser system 12 can be configured to provide the pulses of the optical probe beam OPT_{PRB} at the times corresponding to an approximately equal optical energy of the detection beam OPT_{DET} is provided on the first and second photodetectors 116 and 118 of the optical detector(s) 112 to determine the angle of the external magnetic field B_{EXT}.

For the timing diagram 200, in which the external magnetic field B_{EXT} is provided orthogonally with respect to the optical axis of the optical probe beam OPT_{PRB}, the time during the precession of the alkali metal vapor at which approximately equal optical energy of the detection beam OPT_{DET} is provided on the first and second photodetectors 116 and 118 of the optical detector(s) 112 corresponds to third state 108 in the example of FIG. 3 (e.g., at both 90° and 270°). Therefore, the laser system 12 can provide the optical probe beam OPT_{PRB} pulses at the times T₁ and T₃ in the timing diagram 200 to monitor the magnitude and angle of the external magnetic field B_{EXT}. Deviations of the angle and/or amplitude of the external magnetic field B_{EXT} can thus be observed by the detection system 26 in response to the optical energy of the detection beam OPT_{DET} provided on the first and second photodetectors 116 and 118 of the optical detector(s) 112 being unequal, as described in greater detail in the timing diagram 202.

Similar to the timing diagram 200, the timing diagram 202 demonstrates a sinusoidal spin projection of the magnetic moment vector B_{MM}. However, because of the angle θ₁=45°, the spin projection of the magnetic moment vector B_{MM} along the direction of the optical probe beam OPT_{PRB} is tangent to zero at the time T₂ in the timing diagram 202, corresponding to the 180° precession period being provided along the -Z axis, and thus orthogonal to the 0° precession period. However, because the precession of the magnetic moment vector B_{MM} is conical, and not planar in the example of FIG. 4 based on the external magnetic field B_{EXT} being offset of orthogonal with respect to the optical axis of the optical probe beam OPT_{PRB} by θ₁=45°, the external magnetic field B_{EXT}, as observed by the optical detector(s) 28 via the detection beam(s) OPT_{DET}, is asymmetrical about zero at each 180° interval of the period of the precession. Because the precession of the alkali metal vapor is non-planar, the time at which the detection beam OPT_{DET} provides approximately equal optical energy on the photodetectors 116 and 118 of the optical detector(s) 112 is not aligned with the times T₁ and T₃, as opposed to in the timing diagram 200. Furthermore, in the timing diagram 202, the time at which the detection beam OPT_{DET} provides approximately maximum sensitivity to magnetic field gradients at a time T₅ between the time T₁ and the time T₂, and again at a time T₆ between the times T₂ and T₃. In the example of FIG. 5, the time T₅ occurs just subsequent to the time T₁, and the time T₆ occurs just preceding the time T₃. Therefore, the times T₅ and T₆ are not 180° out-of-phase of each other in the precession period of the alkali metal vapor.

As an example, the detection system 26 can provide the optical probe beam pulses OPT_{PRB} at the appropriate times at which the optical energy of the detection beam OPT_{DET} provided on the first and second photodetectors 116 and 118 is approximately equal based on the timing signal TMR. In response to determining that the optical energy of the detection beam OPT_{DET} provided on the first and second photodetectors 116 and 118 is unequal, the detection beam OPT_{DET} can determine that the angle or the amplitude of the external magnetic field B_{EXT} through the sensor cell 14 is changing. As a result, the timing controller 30 can change the timing signal TMR to modify the times at which the laser system 12 provides the optical probe beam OPT_{PRB} pulses to measure the angle of the external magnetic field B_{EXT}, such as to set the detection beam OPT_{DET} to have approximately equal optical energy of the detection beam OPT_{DET} provided on the first and second photodetectors 116 and 118. Accordingly, in this manner, the detection system 26 can monitor the angle and frequency of the external magnetic field B_{EXT} in a feedback manner.

Therefore, as described herein, the magnitude of the external magnetic field B_{EXT} is determined by the period of the precession of the alkali metal vapor and the angle of the external magnetic field B_{EXT} is determined by the relative timing of orthogonality of the spin projection of the magnetic moment vector B_{MM} along the optical probe beam OPT_{PRB}, and thus the zero-crossings of the solid lines during the respective period as demonstrated in the example of FIG. 5. The laser system 12 can thus provide measurement pulses of the probe beam OPT_{PRB} at respective times when the zero-crossings are expected to occur by the detection system 26 based on monitoring the timing of the zero-crossings during previous measurements. As an example, the measurement pulses of the optical probe beam OPT_{PRB} can be provided at a much higher optical power than the calibration pulses to obtain a highly sensitive measurement of whether the timing of the zero-crossings has deviated from that of the previously monitored measurements, such that corrections can be provided accordingly by the detection system 26 (e.g., via the timing controller 30).

As an example, if the magnitude of the external magnetic field B_{EXT} has changed, more optical power of the respective detection beam OPT_{DET} is observed on either the first photodiode 116 or the second photodiode 118, depending on whether the external magnetic field B_{EXT} has increased or decreased, during both measurement pulses in each period of the precession of the alkali metal vapor. As a result, the precession period of the alkali metal vapor is perceived by the detection system 26 as having changed, thus indicating that the timing controller 30 can change the timing signal TMR to adjust the period of the pulse repetition of providing both the optical pump beam OPT_{PMP} and the optical probe beam OPT_{PRB} accordingly (e.g., more frequent for an increase in amplitude or less frequent for a decrease in amplitude).

As another example, if the angle of the external magnetic field B_{EXT} has changed, the detection system 26 will observe more optical power of the detection beam OPT_{DET} on one of the first and second photodiodes 116 and 118 during the first measurement pulse in each period and more optical power on the other of the first and second photodiodes 116 and 118 during the second measurement pulse. In response to the detection system 26 detecting the opposing disparity of optical power of the detection beam OPT_{DET} on the first and second photodiodes 116 and 118 in the two measurement pulses, the detection system 26 can command the timing controller 30 to change the timing signal TMR to move the timing of the measurement pulses either closer together in time (e.g., if the angle is getting closer to 45°) or farther apart in time (e.g., if the angle is getting closer to 90°).

As an example, at an angle of approximately 45°, the laser system 12 can be commanded via the timing signal TMR to provide a single angle-measurement pulse, occurring at the time T₂. Additionally, measurement pulses of the optical probe beam OPT_{PRB} can be provided during the times of maximum sensitivity to magnetic gradients, corresponding to times T₅ and T₆ in the timing diagram 202, or at times T₁ and T₃ in the timing diagram 200. At any angle of the external magnetic field B_{EXT} between approximately 45° and 90°, up to six optical probe beam OPT_{PRB} pulses can be provided by the laser system 12 per precession period. For example, one optical probe beam OPT_{PRB} pulse can be provided at each of the times T₀/T₄ and the time T₂, one optical probe beam OPT_{PRB} pulse can be provided at each zero-crossing of the spin projection of the magnetic moment vector B_{MM} along the optical probe beam OPT_{PRB} (i.e., the solid line), and one optical probe beam OPT_{PRB} pulse can be provided at each magnitude maximum of the dotted line in the example of FIG. 5.

Thus far, the magnetometer system 10 has been described with respect to determining a scalar value of the amplitude and frequency of the external magnetic field B_{EXT} based on a measurement of the optical detection beam OPT_{DET} through a single measurement zone (e.g., the first measurement zone 20) of the sensor cell 14. For example, the measurement of the optical detection beam OPT_{DET} through the single measurement zone (e.g., the first measurement zone 20) of the sensor cell 14 can facilitate determining the precession of the alkali metal vapor for generating the timing signal TMR via the timing controller 30, and the measurement of the scalar amplitude and frequency of the external magnetic field B_{EXT} based on the determined precession of the alkali metal vapor. However, as described in greater detail herein, the magnetometer system 10 can implement the second and third measurement zones 22 and 24 to determine the magnetic field gradient B_{GRDT} of the external magnetic field B_{EXT}.

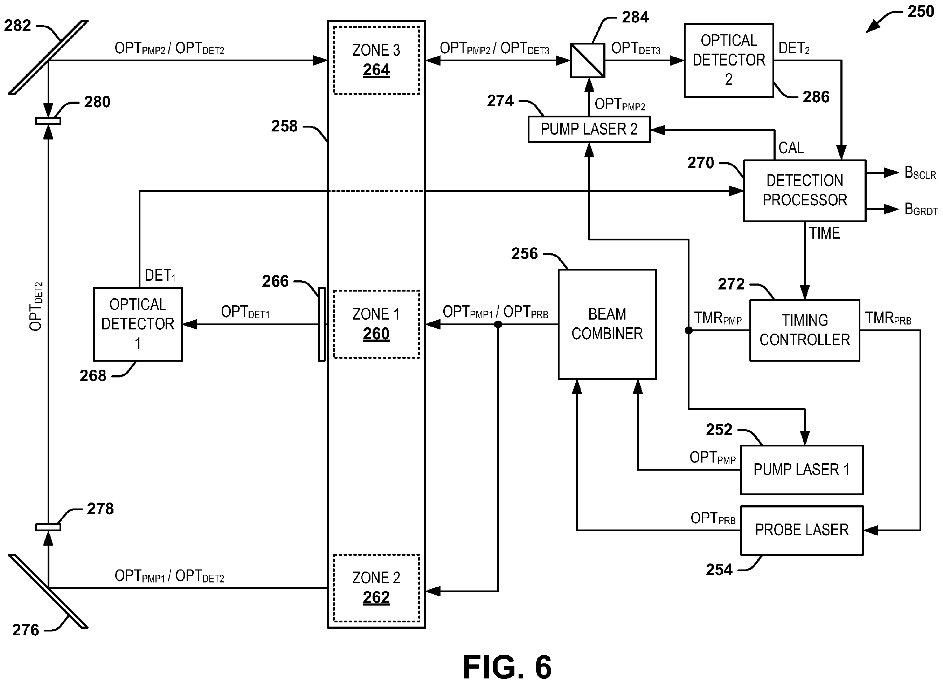

FIG. 6 illustrates an example of a magnetometer system 250 outside the scope of the invention. The magnetometer system 250 can be implemented in any of a variety of applications to measure a magnetic field, such as navigation. For example, the magnetometer system 250 can be implemented in an inertial navigation system (INS) for an aircraft or a spacecraft to assist with real-time navigation or location determination.

The magnetometer system 250 includes a first pump laser 252 and a probe laser 254 that can collectively be part of the laser system 12 in the example of FIG. 1. The first pump laser 252 is configured to generate an optical pump beam OPT_{PMP1}, and the probe laser 254 is configured to generate an optical probe beam OPT_{PRB}. The first optical pump beam OPT_{PMP1} and the optical probe beam OPT_{PRB} are combined via a beam combiner 256. As an example, the beam combiner 256 can be configured as a 2x2 optical combiner to provide power efficient optical coupling (e.g., as opposed to a 2x1 optical combiner that can exhibit a 3dB loss). The beam combiner 256 is demonstrated as providing a combined beam axis, demonstrated in the example of FIG. 6 as OPT_{PMP1} / OPT_{PRB}. The combined beam axis OPT_{PMP1} / OPT_{PRB} can correspond to a coaxial combination of the first optical pump beam OPT_{PMP1} and the optical probe beam OPT_{PRB}. It is to be understood that the first optical pump beam OPT_{PMP1}and the optical probe beam OPT_{PRB} are not necessarily concurrently provided together as the combined beam axis OPT_{PMP1} / OPT_{PRB}, but merely share an optical axis.

The combined beam axis, demonstrated in the example of FIG. 6 as OPT_{PMP1} / OPT_{PRB}, is provided through a sensor cell 258 that includes an alkali metal vapor disposed therein. In the example of FIG. 6, the sensor cell 258 includes a first measurement zone 260 ("ZONE 1"), a second measurement zone 262 ("ZONE 2"), and a third measurement zone 264 ("ZONE 3") that can each correspond to three-dimensional spatial regions within the volume of the sensor cell 258. In the example of FIG. 6, the first measurement zone 260 is arranged approximately centrally along a length of the sensor cell 258, and the second and third measurement zones 262 and 264 are arranged at opposing ends of the sensor cell 258. The combined beam axis OPT_{PMP1}/ OPT_{PRB} is demonstrated in the example of FIG. 6 as being provided through the first measurement zone 260 and the second measurement zone 262 via the beam coupler 256.

As described previously, the first optical pump beam OPT_{PMP1} can be provided through the first and second measurement zones 260 and 262 to facilitate precession of the alkali metal vapor in the first and second measurement zones 260 and 262 in response to the external magnetic field. Therefore, the first optical pump beam OPT_{PMP1} can align the magnetic moment of the alkali metal vapor in an approximately parallel manner with respect to the first optical pump beam OPT_{PMP1}. Therefore, the alkali metal vapor can precess about the external magnetic field based on the alignment of the magnetic moment of the alkali metal vapor, as described with reference to the examples of FIGS. 2-4.

In the example of FIG. 6, a dichroic mirror 266 is demonstrated on the opposite side of the first measurement zone 260 to stop the first optical pump beam OPT_{PMP1} but to allow a first detection beam OPT_{DET1} corresponding to the optical probe beam OPT_{PRB} passing through the first measurement zone 260 to pass to a first optical detector 268. The first optical detector 268 is configured to detect the Faraday rotation of the optical probe beam OPT_{PRB} through the first measurement zone 260 based on the first detection beam OPT_{DET1}. The first optical detector 268 can provide a first detection signal DET₁ to a detection processor 270 that can correspond to a processor of the detection system 26 in the example of FIG. 1. In response to the first detection signal DET₁, the detection processor 270 can generate the scalar magnetic field B_{SCLR} corresponding to the amplitude and angle of the external magnetic field B_{EXT}, as described previously in the examples of FIGS. 2-5.

In addition, the detection processor 270 can generate and adjust a timing reference TIME that is provided to a timing controller 272 that can correspond to the timing controller 30 in the example of FIG. 1. The timing controller 272 can generate a timing signal TMR_{PMP} that is provided to the first pump laser 252 to indicate the timing of activation of the pulses of the first optical pump beam OPT_{PMP1}, similar to as described previously. In the example of FIG. 6, the magnetometer system 250 also includes a second pump laser 274 that is configured to generate a second optical pump beam OPT_{PMP2} that is provided through the third measurement zone 264, as described in greater detail herein. The timing signal TMR_{PMP} is thus also provided to the second pump laser 274 to indicate the timing of activation of the pulses of the second optical pump beam OPT_{PMP2} concurrently with the pulses of the first optical pump beam OPT_{PMP1}. Similarly, the timing controller 272 can generate a timing signal TMR_{PRB} that is provided to the probe laser 254 to indicate the timing of activation of the pulses of the optical probe beam OPT_{PRB}.

In addition, in the example of FIG. 6, the first optical pump beam OPT_{PMP1} and a second detection beam OPT_{DET2} corresponding to the optical probe beam OPT_{PRB} passing through the second measurement zone 262 are demonstrated as a combined beam axis. The first optical pump beam OPT_{PMP1} and the second detection beam OPT_{DET2} are provided to a first mirror 276 to reflect the first optical pump beam OPT_{PMP1} and the second detection beam OPT_{DET2} to a dichroic mirror 278. The dichroic mirror 278 blocks the first pump beam OPT_{PMP1} to provide the second detection beam OPT_{DET2} through another dichroic mirror 280 to reflect from another mirror 282 and through the third measurement zone 264.

As described previously, the second optical pump beam OPT_{PMP2} is provided through the third measurement zone 264. In the example of FIG. 6, the magnetometer system 250 includes a dichroic mirror 284 that is configured to reflect the second optical pump beam OPT_{PMP2} and transmit a third detection beam OPT_{DET3} as part of a combined beam axis that includes a third detection beam OPT_{DET3} corresponding to the second detection beam OPT_{DET2} passing through the third measurement zone 264 in the opposite direction as the second optical pump beam OPT_{PMP2}. In the example of FIG. 6, the second optical pump beam OPT_{PMP2} and the second detection beam OPT_{DET2} occupy a combined beam axis along opposite directions between the mirror 282 and the third measurement zone 264. The dichroic mirror 280 blocks the second optical pump beam OPT_{PMP2}.

The second detection beam OPT_{DET2} experiences a Faraday rotation through the third measurement zone 264, which is exhibited in the third detection beam OPT_{DET3}. In the absence of a magnetic field gradient, the Faraday rotation is approximately identical to the Faraday rotation of the optical probe beam OPT_{PRB} as it passes through the second measurement zone 262. However, because the second detection beam OPT_{DET2} passes through the third measurement zone 264 after having undergone a net 180° reflection after the optical probe beam OPT_{PRB} has passed through the second measurement zone 262, the Faraday rotation experienced by the second detection beam OPT_{DET2} has been reflected; that is, it enters the third measurement zone 264 in a direction that is opposite the Faraday rotation experienced by the optical probe beam OPT_{PRB}. Therefore, the third detection beam OPT_{DET3} thus exhibits the Faraday rotation experienced by the second detection beam OPT_{DET2}, similar to the second detection beam OPT_{DET2} exhibiting the Faraday rotation experienced by the optical probe beam OPT_{PRB}, in the same rotation direction. The third detection beam OPT_{DET3} is provided through to a second optical detector 286. The second optical detector 286 is configured to detect the Faraday rotation of the second detection beam OPT_{DET2} through the third measurement zone 264 based on the third detection beam OPT_{DET3}, and thus determines a difference in Faraday rotation between the second and third measurement zones 262 and 264, as described in greater detail herein. The second optical detector 286 can provide a second detection signal DET₂ to the detection processor 270 to determine the magnetic field gradient B_{GRDT}, as described in greater detail herein.

As an example, if the conditions of the alkali metal vapor in each of the second and third measurement zones 262 and 264 are approximately the same, then the Faraday rotation of the optical probe beam OPT_{PRB} through the second measurement zone 262, as provided by the second detection beam OPT_{DET2} and after reflection from mirrors 276 and 282, will be approximately equal and opposite the Faraday rotation of the second detection beam OPT_{DET2} through the third measurement zone 264, as provided by the third detection beam OPT_{DET3}. As an example, the conditions can include the density of the alkali metal vapor, temperature of the sensor cell 258, or other varying calibration conditions differ between the second and third measurement zones 262 and 264. As another example, if the amplitude of the external magnetic field B_{EXT} is the same in the second and third measurement zones 262 and 264 (e.g., there is no magnetic field gradient of the external magnetic field B_{EXT}), then similarly, the Faraday rotation of the optical probe beam OPT_{PRB} through the second measurement zone 262, as provided by the second detection beam OPT_{DET2}, will after reflecting from mirrors 276 and 282 be approximately equal and opposite the Faraday rotation of the second detection beam OPT_{DET2} through the third measurement zone 264, as provided by the third detection beam OPT_{DET3}. However, variations in the conditions of the alkali metal vapor in each of the second and third measurement zones 262 and 264 can result in a different amount of Faraday rotation.

As a result, upon the detection processor 270 determining that the third detection beam OPT_{DET3} has a non-zero Faraday rotation via the second optical detector 286, then the detection processor 270 can determine that either the conditions of the alkali metal vapor, as described previously, are different, or a magnetic field gradient of the external magnetic field B_{EXT} exists. For example, the detection processor 270 can determine if there is a non-zero Faraday rotation of the second detection beam OPT_{DET2} based on the third detection beam OPT_{DET3} during the calibration pulses of the optical probe beam OPT_{PRB}, such as provided in the first and second states 104 and 106 described in the example of FIG. 3.

If a non-zero Faraday rotation of the second detection beam OPT_{DET2} based on the third detection beam OPT_{DET3} detected during the calibration pulses of the optical probe beam OPT_{PRB}, then the detection processor 270 can determine that the conditions of the alkali metal vapor (e.g., density, population, and/or temperature) are different between the second and third measurement zones 262 and 264. In response, the detection processor 270 can adjust the power of the second pump laser 274, such that the second optical pump beam OPT_{PMP2} can compensate for the different conditions of the alkali metal vapor in a feedback manner. If the detection processor 270 determines that there is no (e.g., net zero) Faraday rotation of the second detection beam OPT_{DET2} based on the third detection beam OPT_{DET3} detected during the calibration pulses of the optical probe beam OPT_{PRB}, then the detection processor 270 can determine that the conditions of the alkali metal vapor (e.g., density, population, and/or temperature) between the second and third measurement zones 262 and 264 are approximately the same, and thus that the magnetometer system 10 is calibrated with respect to the conditions of the alkali metal vapor in the sensor cell 258. However, if the detection processor 270 determines that there is no (e.g., net zero) Faraday rotation of the second detection beam OPT_{DET2} based on the third detection beam OPT_{DET3} is detected during the calibration pulses of the optical probe beam OPT_{PRB}, but determines that there is a non-zero Faraday rotation of the second detection beam OPT_{DET2} based on the third detection beam OPT_{DET3} during the interrogation pulses (e.g., during the third state 108 in the example of FIG. 3, such as corresponding to the times T₅ and T₆ in the example of FIG. 5), then the detection processor 270 can determine that there is a magnetic field gradient in the external magnetic field B_{EXT}. Accordingly, the detection processor 270 can measure the magnetic field gradient B_{GRDT} based on the detected Faraday rotation via the third detection beam OPT_{DET3}.

As an example, the magnetometer system 250 can provide optical pumping and detection through multiple axes of the sensor cell 258 to provide greater precision and vector amplitude detection of the external magnetic field B_{EXT}. For example, the magnetometer system 250 can include optics or additional pump and probe lasers to provide optical pump beam(s) and optical probe beam(s) through at least one other orthogonal axis of the sensor cell 258 to provide additional measurements of the external magnetic field B_{EXT}. Accordingly, the magnetometer system 250 can measure the amplitude, vector angles, and magnetic field gradients associated with the external magnetic field B_{EXT} based on providing pump and probe beam pulses through multiple orthogonal directions through the sensor cell 258.

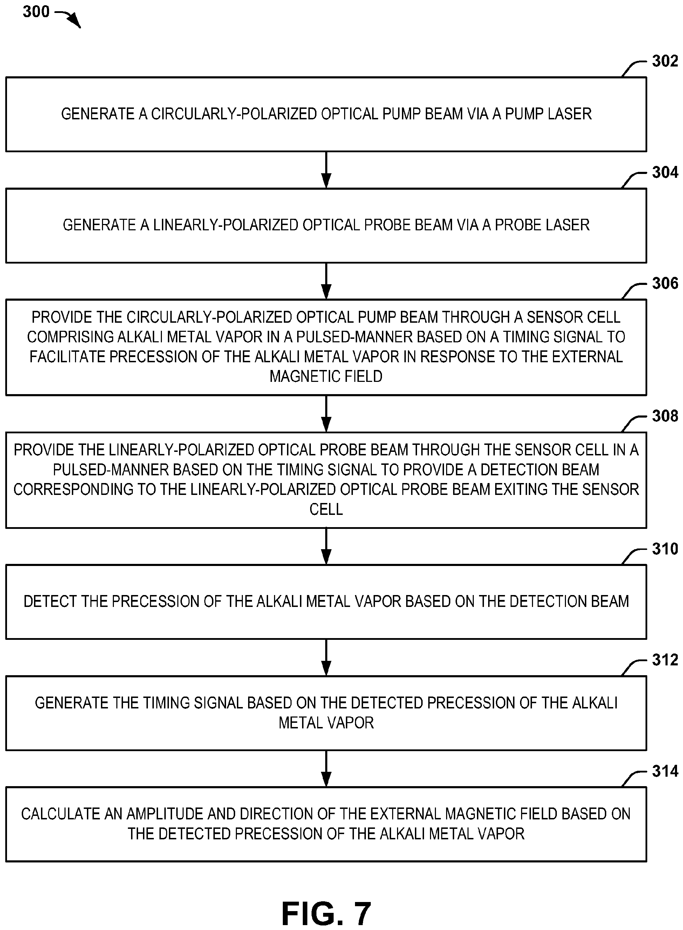

In view of the foregoing structural and functional features described above, a methodology in accordance with various aspects of the present invention will be better appreciated with reference to FIG. 7. While, for purposes of simplicity of explanation, the methodology of FIG. 7 is shown and described as executing serially, it is to be understood and appreciated that the present invention is not limited by the illustrated order, as some aspects could, in accordance with the present invention, occur in different orders and/or concurrently with other aspects from that shown and described herein. Moreover, not all illustrated features may be required to implement a methodology in accordance with an aspect of the present invention.

FIG. 7 illustrates an example of a method 300 for measuring an external magnetic field (e.g., the external magnetic field B_{EXT}). At 302, a circularly-polarized optical pump beam (e.g., the optical pump beam OPT_{PMP}) is generated via a pump laser (e.g., the pump laser(s) 14). At 304, a linearly-polarized optical probe beam (e.g., the optical probe beam OPT_{PRB}) is generated via a probe laser (e.g., the probe laser(s) 16). At 306, the circularly-polarized optical pump beam is provided through a sensor cell (e.g., the sensor cell 18) comprising alkali metal vapor in a pulsed-manner based on a timing signal (e.g., the timing signal TMR) to facilitate precession of the alkali metal vapor in response to the external magnetic field. At 308, the linearly-polarized optical probe beam is provided through the sensor cell in a pulsed-manner based on the timing signal to provide a detection beam (e.g., the detection beam OPT_{DET}) corresponding to the linearly-polarized optical probe beam exiting the sensor cell. At 310, the precession of the alkali metal vapor is detected based on the detection beam. At 312, the timing signal is generated based on the detected precession of the alkali metal vapor. At 314, an amplitude and direction of the external magnetic field are calculated based on the detected precession of the alkali metal vapor.

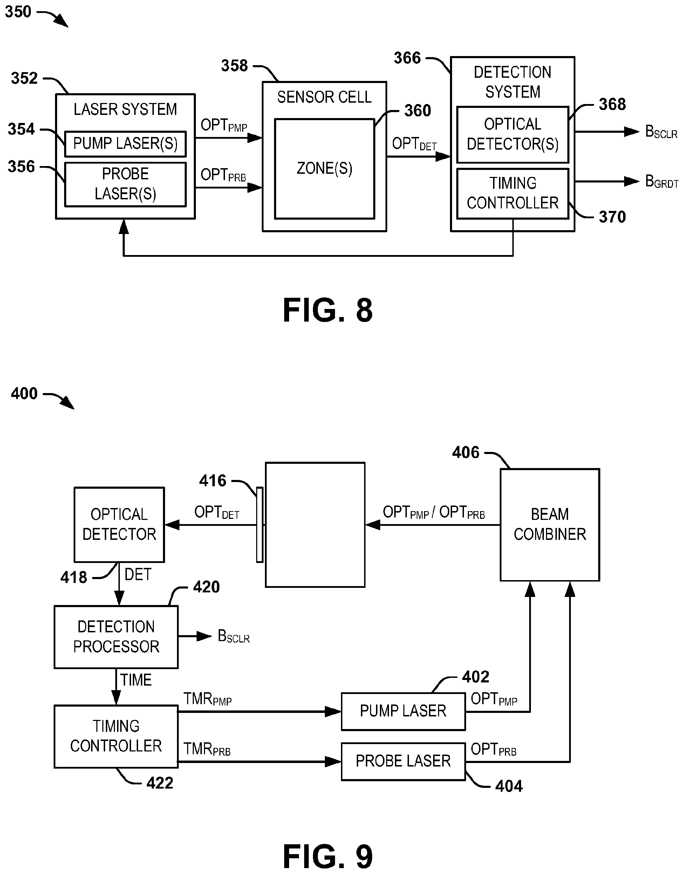

FIG. 8 illustrates another example of a magnetometer system 350. The magnetometer system 350 can be implemented in any of a variety of applications to measure a magnetic field, such as navigation. For example, the magnetometer system 350 can be implemented in an INS for an aircraft or a spacecraft to assist with real-time navigation or location determination.

The magnetometer system 350 includes a laser system 352 that includes at least one pump laser 354 and at least one probe laser 356. The pump laser(s) 354 are each configured to generate a respective optical pump beam OPT_{PMP}, and the probe laser(s) 356 are each configured to generate a respective optical probe beam OPT_{PRB}. The optical pump beam(s) OPT_{PMP} and the optical probe beam(s) OPT_{PRB} are each provided through a sensor cell 358 that includes an alkali metal vapor disposed therein. In the example of FIG. 8, the sensor cell 358 includes at least one measurement zone 360 ("ZONE(S)") that can each correspond to three-dimensional spatial regions within the volume of the sensor cell 358. As an example, the measurement zone(s) 360 can include a single measurement zone corresponding to substantially the entirety of the sensor cell 358, or can include a pair of measurement zones arranged at opposing ends of the sensor cell 358 in accordance with the claimed invention.

As described in greater detail herein, the measurement zone(s) 360 can be implemented for calibration of the magnetometer system 350, for determining the amplitude and direction of an external magnetic field, for determining a magnetic field gradient associated with the external magnetometer, and/or for feedback to generate a timing signal associated with the precession of the alkali metal vapor.

The optical pump beam OPT_{PMP} can be provided through the sensor cell 358 to facilitate precession of the alkali metal vapor in response to the external magnetic field. As an example, the optical pump beam OPT_{PMP} can be circularly-polarized, such that the angular momentum of the photons of the optical pump beam OPT_{PMP} can be absorbed by the alkali metal vapor (e.g., based on the wavelength of the optical pump beam OPT_{PMP}). Therefore, the optical pump beam OPT_{PMP} can align the magnetic moment of the alkali metal vapor in an approximately parallel manner with respect to the optical pump beam OPT_{PMP}. Therefore, the alkali metal vapor can precess about the external magnetic field based on the alignment of the magnetic moment of the alkali metal vapor, similar to as described previously with respect to FIGS. 2-4.

The magnetometer system 350 can also include a detection system 366. The detection system 366 is configured to monitor at least one detection beam OPT_{DET} that is provided from the sensor cell 358. As an example, the detection beam(s) OPT_{DET} can correspond to the optical probe beam OPT_{PRB} being provided through at least one of the respective measurement zone(s) 360 and exiting the sensor cell 358. As described previously, the optical probe beam OPT_{PRB} can be provided as linearly-polarized. Therefore, based on the precession of the magnetic moment vector B_{MM} of the alkali metal vapor, the optical probe beam OPT_{PRB} can experience Faraday rotation, such that the respective detection beam(s) OPT_{DET} can exhibit the Faraday rotation that can be indicative of the precession of the alkali metal vapor based on the external magnetic field B_{EXT}.

In the example of FIG. 8, the detection system 366 includes at least one optical detector 368 that is configured to detect the Faraday rotation of the respective detection beam(s) OPT_{DET} to monitor the precession of the alkali metal vapor in response to the external magnetic field B_{EXT}. As an example, the optical detector(s) 368 can be configured as a polarization beamsplitter and set of photodetectors (e.g., photodiodes) that can measure a relative Faraday rotation of the detection beam(s) OPT_{DET}. Therefore, based on the measured Faraday rotation of the detection beam(s) OPT_{DET}, the detection system 366 can calculate an amplitude and direction of the external magnetic field B_{EXT}, as described in greater detail herein. In the example of FIG. 8, the detection system 366 is demonstrated as calculating a scalar amplitude and direction of the external magnetic field B_{EXT}, demonstrated as a signal B_{SCLR}. As another example, the detection system 366 can calculate a magnetic field gradient of the external magnetic field B_{EXT}, demonstrated as a signal B_{GRDT}.

In the example of FIG. 8, the detection system 366 also includes a timing controller 370. As described previously, the laser system 352 can provide the optical pump beam OPT_{PMP} via the pump laser 354 in a pulsed manner, and can likewise provide the optical probe beam OPT_{PRB} via the probe laser 356 in a pulsed manner. The laser system 352 can provide the pulses of the optical pump beam OPT_{PMP} and the optical probe beam OPT_{PRB} in response to a timing signal TMR that is generated by the timing controller 370 in response to the detection beam(s) OPT_{DET}. For example, the timing signal TMR can correspond to the period of the precession of the alkali metal vapor, such that the timing signal TMR can provide an indication to the laser system 352 as to the time to activate the pump laser(s) 354 to provide the pulse(s) of the optical pump beam OPT_{PMP} and as to the time to activate the probe laser(s) 356 to provide the pulse(s) of the optical probe beam OPT_{PRB}, similar to as described previously.

FIG. 9 illustrates another example of a magnetometer system 400. The magnetometer system 400 can be implemented in any of a variety of applications to measure a magnetic field, such as navigation. For example, the magnetometer system 400 can be implemented in an INS for an aircraft or a spacecraft to assist with real-time navigation or location determination.

The magnetometer system 400 includes a pump laser 402 and a probe laser 404 that can collectively be part of the laser system 352 in the example of FIG. 8. The pump laser 402 is configured to generate an optical pump beam OPT_{PMP1}, and the probe laser 404 is configured to generate an optical probe beam OPT_{PRB}. The optical pump beam OPT_{PMP} and the optical probe beam OPT_{PRB} are combined via a beam combiner 406. As an example, the beam combiner 406 can be configured as a 2x2 optical combiner to provide power efficient optical coupling (e.g., as opposed to a 2x1 optical combiner that can exhibit a 3dB loss). The beam combiner 406 is demonstrated as providing a combined beam axis, demonstrated in the example of FIG. 9 as OPT_{PMP} / OPT_{PRB}. The combined beam axis OPT_{PMP} / OPT_{PRB} can correspond to a coaxial combination of the optical pump beam OPT_{PMP} and the optical probe beam OPT_{PRB}. It is to be understood that the optical pump beam OPT_{PMP} and the optical probe beam OPT_{PRB} are not necessarily concurrently provided together as the combined beam axis OPT_{PMP} / OPT_{PRB}, but merely share an optical axis.

The combined beam axis, demonstrated in the example of FIG. 9 as OPT_{PMP} / OPT_{PRB}, is provided through a sensor cell 408 that includes an alkali metal vapor disposed therein. In the example of FIG. 9, the sensor cell 408 includes only a single measurement zone, as opposed to the sensor cell 258 in the example of FIG. 6. Therefore, as described herein in the example of FIG. 9, the magnetometer system 400 is configured to determine the scalar amplitude B_{SCLR} of the external magnetic field B_{EXT}, as opposed to also determining the magnetic field gradient B_{GRDT}. In the example of FIG. 9, the single measurement zone corresponds to thbe substantial entirety of the sensor cell 408, and thus is referred to hereinafter as the sensor cell 408. The combined beam axis OPT_{PMP} / OPT_{PRB} is demonstrated in the example of FIG. 9 as being provided through the sensor cell 408 via the beam coupler 406.

As described previously, the optical pump beam OPT_{PMP} can be provided through the sensor cell 408 to facilitate precession of the alkali metal vapor in the sensor cell 408 in response to the external magnetic field. Therefore, the optical pump beam OPT_{PMP} can align the magnetic moment of the alkali metal vapor in an approximately parallel manner with respect to the optical pump beam OPT_{PMP}. Therefore, the alkali metal vapor can precess about the external magnetic field based on the alignment of the magnetic moment of the alkali metal vapor, as described with reference to the examples of FIGS. 2-4.

In the example of FIG. 9, a dichroic mirror 416 is demonstrated on the opposite side of the sensor cell 408 to stop the optical pump beam OPT_{PMP} but to allow a detection beam OPT_{DET} corresponding to the optical probe beam OPT_{PRB} passing through the sensor cell 408 to pass to an optical detector 418. The optical detector 418 is configured to detect the Faraday rotation of the optical probe beam OPT_{PRB} through the sensor cell 408 based on the detection beam OPT_{DET}. The optical detector 418 can provide a detection signal DET to a detection processor 420 that can correspond to a processor of the detection system366 in the example of FIG. 8. In response to the detection signal DET, the detection processor 420 can generate the scalar magnetic field B_{SCLR} corresponding to the amplitude and angle of the external magnetic field B_{EXT}, as described previously in the examples of FIGS. 2-5.

In addition, the detection processor 420 can generate and adjust a timing reference TIME that is provided to a timing controller 422 that can correspond to the timing controller 370 in the example of FIG. 8. The timing controller 422 can generate a timing signal TMR_{PMP} that is provided to the pump laser 402 to indicate the timing of activation of the pulses of the optical pump beam OPT_{PMP}, similar to as described previously. Similarly, the timing controller 422 can generate a timing signal TMR_{PRB} that is provided to the probe laser 404 to indicate the timing of activation of the pulses of the optical probe beam OPT_{PRB}.

As an example, the magnetometer system 400 can provide optical pumping and detection through multiple axes of the sensor cell 408 to provide greater precision and vector amplitude detection of the external magnetic field B_{EXT}. For example, the magnetometer system 400 can include optics or additional pump and probe lasers to provide optical pump beam(s) and optical probe beam(s) through at least one other orthogonal axis of the sensor cell 408 to provide additional measurements of the external magnetic field B_{EXT}. Accordingly, the magnetometer system 400 can measure the amplitude, vector angles, and magnetic field gradients associated with the external magnetic field B_{EXT} based on providing pump and probe beam pulses through multiple orthogonal directions through the sensor cell 408. Furthermore, the magnetometer system 400 in the example of FIG. 9 demonstrates a more simplistic magnetometer system relative to the magnetometer system 250 in the example of FIG. 6 for determining the whole-field measurement (e.g., scalar and vector amplitudes) of the external magnetic field B_{EXT}.

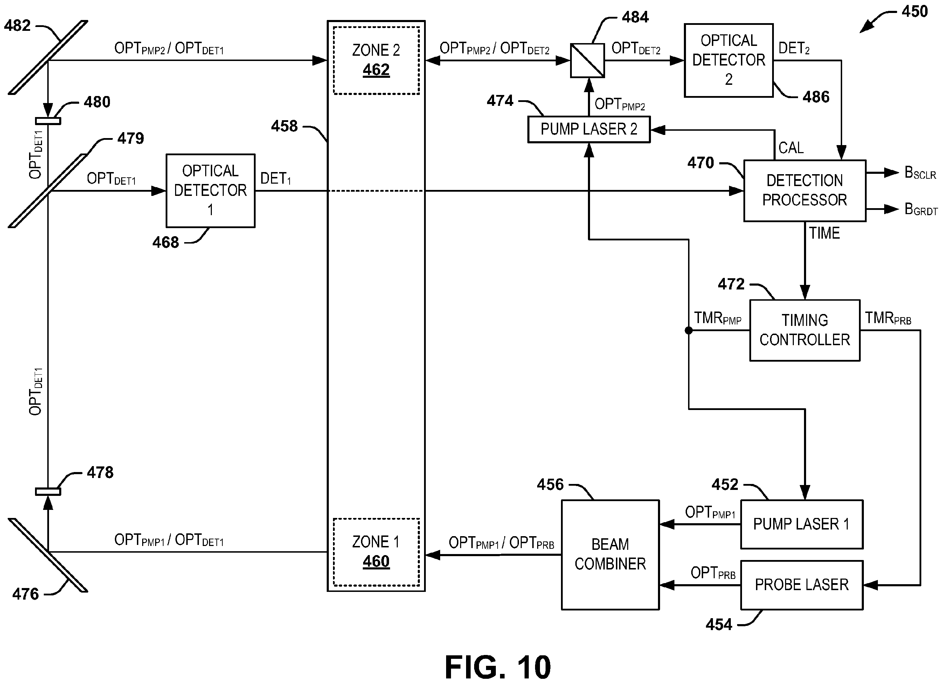

FIG. 10 illustrates an example of a magnetometer system 450 in accordance with the invention. The magnetometer system 450 can be implemented in any of a variety of applications to measure a magnetic field, such as navigation. For example, the magnetometer system 450 can be implemented in an inertial navigation system (INS) for an aircraft or a spacecraft to assist with real-time navigation or location determination.

The magnetometer system 450 includes a first pump laser 452 and a probe laser 454 that can collectively be part of the laser system 352 in the example of FIG. 8. The first pump laser 452 is configured to generate an optical pump beam OPT_{PMP1}, and the probe laser 454 is configured to generate an optical probe beam OPT_{PRB}. The first optical pump beam OPT_{PMP1} and the optical probe beam OPT_{PRB} are combined via a beam combiner 456. As an example, the beam combiner 456 can be configured as a 2x2 optical combiner to provide power efficient optical coupling (e.g., as opposed to a 2×1 optical combiner that can exhibit a 3dB loss). The beam combiner 456 is demonstrated as providing a combined beam axis, demonstrated in the example of FIG. 10 as OPT_{PMP1} / OPT_{PRB}. The combined beam axis OPT_{PMP1} / OPT_{PRB} can correspond to a coaxial combination of the first optical pump beam OPT_{PMP1} and the optical probe beam OPT_{PRB}. It is to be understood that the first optical pump beam OPT_{PMP1} and the optical probe beam OPT_{PRB} are not necessarily concurrently provided together as the combined beam axis OPT_{PMP1} / OPT_{PRB}, but merely share an optical axis.

The combined beam axis, demonstrated in the example of FIG. 10 as OPT_{PMP1} / OPT_{PRB}, is provided through a sensor cell 458 that includes an alkali metal vapor disposed therein. In the example of FIG. 10, the sensor cell 458 includes a first measurement zone 460 ("ZONE 1") and a second measurement zone 462 ("ZONE 2") that can each correspond to three-dimensional spatial regions within the volume of the sensor cell 458. In the example of FIG. 10, the first and second measurement zones 460 and 462 are arranged at opposing ends of the sensor cell 458. The combined beam axis OPT_{PMP1} / OPT_{PRB} is demonstrated in the example of FIG. 10 as being provided through the first measurement zone 460 via the beam coupler 456.

As described previously, the first optical pump beam OPT_{PMP1} is provided through the first measurement zone 460 to facilitate precession of the alkali metal vapor in the first measurement zone 460 in response to the external magnetic field. Therefore, the first optical pump beam OPT_{PMP1} aligns the magnetic moment of the alkali metal vapor in an approximately parallel manner with respect to the first optical pump beam OPT_{PMP1}. Therefore, the alkali metal vapor can precess about the external magnetic field based on the alignment of the magnetic moment of the alkali metal vapor, as described with reference to the examples of FIGS. 2-4.

In the example of FIG. 10, the first optical pump beam OPT_{PMP1} and the first detection beam OPT_{DET1} corresponding to the optical probe beam OPT_{PRB} passing through the first measurement zone 460 are demonstrated as a combined beam axis. The first optical pump beam OPT_{PMP1} and the first detection beam OPT_{DET1} are provided to a first mirror 476 to reflect the first optical pump beam OPT_{PMP1} and the first detection beam OPT_{DET1} to a dichroic mirror 478. The dichroic mirror 478 blocks the first pump beam OPT_{PMP1} to provide the first detection beam OPT_{DET1} through a beamsplitter 479 and another dichroic mirror 480 to reflect from another mirror 482 and through the second measurement zone 462. As an example, the beamsplitter 479 can be a partially-silvered mirror or a dichroic mirror configured to pass a first portion of the first detection beam OPT_{DET1} and to reflect a second portion of the first detection beam OPT_{DET1}.

The reflected second portion of the first detection beam OPT_{DET1} is provided to a first optical detector 468. The first optical detector 468 is configured to detect the Faraday rotation of the optical probe beam OPT_{PRB} through the first measurement zone 460 based on the first detection beam OPT_{DET1}. The first optical detector 468 provides a first detection signal DET₁ to a detection processor 470 that can correspond to a processor of the detection system 366 in the example of FIG. 8. In response to the first detection signal DET₁, the detection processor 470 can generate the scalar magnetic field B_{SCLR} corresponding to the amplitude and angle of the external magnetic field B_{EXT}, as described previously in the examples of FIGS. 2-5.

In addition, the detection processor 470 generates and adjusts a timing reference TIME that is provided to a timing controller 472 that can correspond to the timing controller 370 in the example of FIG. 8. The timing controller 472 generates a timing signal TMR_{PMP} that is provided to the first pump laser 452 to indicate the timing of activation of the pulses of the first optical pump beam OPT_{PMP1}, similar to as described previously. In the example of FIG. 10, the magnetometer system 450 also includes a second pump laser 474 that is configured to generate a second optical pump beam OPT_{PMP2} that is provided through the second measurement zone 462, as described in greater detail herein. The timing signal TMR_{PMP} is thus also provided to the second pump laser 474 to indicate the timing of activation of the pulses of the second optical pump beam OPT_{PMP2} concurrently with the pulses of the first optical pump beam OPT_{PMP1}. Similarly, the timing controller 472 generates a timing signal TMR_{PRB} that is provided to the probe laser 454 to indicate the timing of activation of the pulses of the optical probe beam OPT_{PRB}.

As described previously, the second optical pump beam OPT_{PMP2} is provided through the second measurement zone 462. In the example of FIG. 10, the magnetometer system 450 includes a dichroic mirror 484 that is configured to reflect the second optical pump beam OPT_{PMP2} and transmit a second detection beam OPT_{DET2} as part of a combined beam axis that includes a second detection beam OPT_{DET2} corresponding to the first detection beam OPT_{DET1} passing through the second measurement zone 462 in the opposite direction as the second optical pump beam OPT_{PMP2}. In the example of FIG. 10, the second optical pump beam OPT_{PMP2} and the first detection beam OPT_{DET1} occupy a combined beam axis along opposite directions between the mirror 482 and the second measurement zone 462. The dichroic mirror 480 blocks the second optical pump beam OPT_{PMP2}.

The first detection beam OPT_{DET1} experiences a Faraday rotation through the second measurement zone 462, which is exhibited in the second detection beam OPT_{DET2}. In the absence of a magnetic field gradient, the Faraday rotation is approximately identical to the Faraday rotation of the optical probe beam OPT_{PRB} as it passes through the first measurement zone 460. However, because the first detection beam OPT_{DET1} passes through the second measurement zone 462 after having undergone a net 180° reflection after the optical probe beam OPT_{PRB} has passed through the first measurement zone 460, the Faraday rotation experienced by the first detection beam OPT_{DET1} has been reflected; that is, it enters the second measurement zone 462 in a direction that is opposite the Faraday rotation experienced by the optical probe beam OPT_{PRB}. Therefore, the second detection beam OPT_{DET2} thus exhibits the Faraday rotation experienced by the first detection beam OPT_{DET1}, similar to the first detection beam OPT_{DET1} exhibiting the Faraday rotation experienced by the optical probe beam OPT_{PRB}, in the same rotation direction. The second detection beam OPT_{DET2} is provided through to a second optical detector 486. The second optical detector 486 is configured to detect the Faraday rotation of the first detection beam OPT_{DET1} through the second measurement zone 462 based on the second detection beam OPT_{DET2}, and thus determines a difference in Faraday rotation between the first and second measurement zones 460 and 462, as described in greater detail herein. The second optical detector 486 can provide a second detection signal DET₂ to the detection processor 470 to determine the magnetic field gradient B_{GRDT}, as described in greater detail herein.

As an example, if the conditions of the alkali metal vapor in each of the first and second measurement zones 460 and 462 are approximately the same, then the Faraday rotation of the optical probe beam OPT_{PRB} through the first measurement zone 460, as provided by the first detection beam OPT_{DET1} and after reflection from mirrors 476 and 482, will be approximately equal and opposite the Faraday rotation of the first detection beam OPT_{DET1} through the second measurement zone 462, as provided by the second detection beam OPT_{DET2}. As an example, the conditions can include the density of the alkali metal vapor, temperature of the sensor cell 458, or other varying calibration conditions differ between the first and second measurement zones 460 and 462. As another example, if the amplitude of the external magnetic field B_{EXT} is the same in the first and second measurement zones 460 and 462 (e.g., there is no magnetic field gradient of the external magnetic field B_{EXT}), then similarly, the Faraday rotation of the optical probe beam OPT_{PRB} through the first measurement zone 460, as provided by the first detection beam OPT_{DET1}, will after reflecting from mirrors 476 and 482 be approximately equal and opposite the Faraday rotation of the first detection beam OPT_{DET1} through the second measurement zone 462, as provided by the second detection beam OPT_{DET2}. However, variations in the conditions of the alkali metal vapor in each of the first and second measurement zones 460 and 462 can result in a different amount of Faraday rotation.

As a result, upon the detection processor 470 determining that the second detection beam OPT_{DET2} has a non-zero Faraday rotation via the second optical detector 486, then the detection processor 470 can determine that either the conditions of the alkali metal vapor, as described previously, are different, or a magnetic field gradient of the external magnetic field B_{EXT} exists. For example, the detection processor 470 can determine if there is a non-zero Faraday rotation of the first detection beam OPT_{DET1} based on the second detection beam OPT_{DET2} during the calibration pulses of the optical probe beam OPT_{PRB}, such as provided in the first and second states 104 and 106 described in the example of FIG. 3.

If a non-zero Faraday rotation of the first detection beam OPT_{DET1} based on the second detection beam OPT_{DET2} is detected during the calibration pulses of the optical probe beam OPT_{PRB}, then the detection processor 470 can determine that the conditions of the alkali metal vapor (e.g., density, population, and/or temperature) are different between the first and second measurement zones 460 and 462. In response, the detection processor 470 can adjust the power of the second pump laser 474, such that the second optical pump beam OPT_{PMP2} can compensate for the different conditions of the alkali metal vapor in a feedback manner. If the detection processor 470 determines that there is no (e.g., net zero) Faraday rotation of the first detection beam OPT_{DET1} based on the second detection beam OPT_{DET2} detected during the calibration pulses of the optical probe beam OPT_{PRB}, then the detection processor 470 can determine that the conditions of the alkali metal vapor (e.g., density, population, and/or temperature) between the first and second measurement zones 460 and 462 are approximately the same, and thus that the magnetometer system 350 is calibrated with respect to the conditions of the alkali metal vapor in the sensor cell 458. However, if the detection processor 470 determines that there is no (e.g., net zero) Faraday rotation of the first detection beam OPT_{DET1} based on the second detection beam OPT_{DET2} detected during the calibration pulses of the optical probe beam OPT_{PRB}, but determines that there is a non-zero Faraday rotation of the first detection beam OPT_{DET1} based on the second detection beam OPT_{DET2} during the interrogation pulses (e.g., during the third state 108 in the example of FIG. 3, such as corresponding to the times T₅ and T₆ in the example of FIG. 5), then the detection processor 470 can determine that there is a magnetic field gradient in the external magnetic field B_{EXT}. Accordingly, the detection processor 470 can measure the magnetic field gradient B_{GRDT} based on the detected Faraday rotation via the second detection beam OPT_{DET2}.

As an example, the magnetometer system 450 can provide optical pumping and detection through multiple axes of the sensor cell 458 to provide greater precision and vector amplitude detection of the external magnetic field B_{EXT}. For example, the magnetometer system 450 can include optics or additional pump and probe lasers to provide optical pump beam(s) and optical probe beam(s) through at least one other orthogonal axis of the sensor cell 458 to provide additional measurements of the external magnetic field B_{EXT}. Accordingly, the magnetometer system 450 can measure the amplitude, vector angles, and magnetic field gradients associated with the external magnetic field B_{EXT} based on providing pump and probe beam pulses through multiple orthogonal directions through the sensor cell 458. Furthermore, the magnetometer system 450 in the embodiment of FIG. 10 demonstrates a more simplistic magnetometer system relative to the magnetometer system 250 in the example of FIG. 6 (which is outside the scope of the current invention) for determining the whole-field measurement (e.g., scalar and vector amplitudes) of the external magnetic field B_{EXT}, as well as the magnetic field gradient B_{GRDT} of the external magnetic field B_{EXT}, based on implementing only two measurement zones of the sensor cell 458 instead of three.

What have been described above are examples of the present invention. It is, of course, not possible to describe every conceivable combination of components or methodologies for purposes of describing the present invention, but one of ordinary skill in the art will recognize that many further combinations and permutations of the present invention are possible. Accordingly, the present invention is intended to embrace all such alterations, modifications and variations that fall within the scope of the appended claims.

Additionally, where the disclosure or claims recite "a," "an," "a first," or "another" element, or the equivalent thereof, it should be interpreted to include one or more than one such element, neither requiring nor excluding two or more such elements. As used herein, the term "includes" means includes but not limited to, and the term "including" means including but not limited to. The term "based on" means based at least in part on.

## Claims

1. A magnetometer system (450) comprising:
a sensor cell (458) comprising alkali metal vapor, a first measurement zone (460), and a second measurement (462) zone arranged at opposite ends of the sensor cell (458), each of the first and second measurement zones (460, 462) corresponding to a three-dimensional spatial region within the sensor cell (458);
a laser system (452, 454) configured to provide a circularly-polarized optical pump beam through the sensor cell (458) in a pulsed manner to facilitate precession of the alkali metal vapor in the first and second measurement zones (460, 462) in response to an external magnetic field and to provide a linearly-polarized optical probe beam through the sensor cell (458) in a pulsed manner based on a precession frequency of the alkali metal vapor;
a detection system (468, 486, 470) configured to detect the precession of the alkali metal vapor in response to a first detection beam and a second detection beam corresponding to the linearly-polarized optical probe beam exiting the sensor cell (458) through each of the respective measurement zones (460, 462), respectively, and to calculate an amplitude and direction of the external magnetic field based on the detected precession of the alkali metal vapor, the detection system comprising a first optical detector (468) and a second optical detector (486) configured to detect precession of the alkali metal vapor, the detection system further comprising a timing controller (472) configured to generate a timing signal based on the detected precession of the alkali metal vapor and to control timing of application of pulses associated with the circularly-polarized optical pump beam and to control timing of application of pulses associated with the linearly-polarized optical probe beam based on the timing signal to track changes in the amplitude and/or direction of the external magnetic field; and
a beamsplitter (479) configured to split the first detection beam into a first portion of the first detection beam and a second portion of the first detection beam, the beamsplitter (479) being further configured to provide the first portion of the first detection beam to the second optical detector (486) through the second measurement zone (462) and to provide the second portion of the first detection beam to the first optical detector (468).

2. The system (450) of claim 1, wherein the circularly-polarized optical pump beam is provided through each of the first and second measurement zones (460, 462), wherein the linearly-polarized optical probe beam is provided through the first measurement zone (460) in the pulsed manner to calculate the amplitude and direction of the external magnetic field, wherein the linearly-polarized optical probe beam is provided through each of the first and second measurement zones (460, 462) to calculate a magnetic field gradient across the sensor cell.

3. The system (450) of claim 1, wherein the laser system comprises a 2x2 optical coupler (456) configured to axially combine the circularly-polarized optical pump beam and the linearly-polarized optical probe beam as a combined beam axis through the first measurement zone (460) to generate the first detection beam based on the linearly-polarized optical probe beam, wherein the first detection beam is reflected through the second measurement zone (462) to generate the second detection beam, such that the second detection beam is associated with the precession of the alkali metal vapor in each of the first and second measurement zones (460, 462).

4. The system (450) of claim 1, wherein the laser system comprises:
a first pump laser (452) configured to generate a first circularly-polarized optical pump beam that is provided through the first measurement zone (460) in a pulsed manner to facilitate precession of the alkali metal vapor in the first measurement zone (460) in response to the external magnetic field; and
a second pump laser (474) configured to generate a second circularly-polarized optical pump beam that is provided through the second measurement zone (462) to facilitate precession of the alkali metal vapor in the second measurement zone (462) in response to the external magnetic field.

5. The system (450) of claim 4, wherein the laser system further comprises a probe laser (454) configured to generate the linearly-polarized optical probe beam, wherein the linearly-polarized optical probe beam is configured to provide a calibration optical probe beam concurrently with each of the first and second circularly-polarized optical pump beams, wherein the laser system is further configured to calibrate the second pump laser (474) in response to a difference between the first detection beam and the second detection beam.

6. The system (450) of claim 5, wherein the linearly-polarized optical probe beam is configured to provide a startup beam at an initial startup of the magnetometer system (450) to provide an initial detection beam, wherein the detection system (468, 486, 470) is configured to generate an initial estimate of the precession frequency of the alkali metal vapor and to determine an initial amplitude and direction of the external magnetic field based on the initial estimate of the precession frequency.

7. The system (450) of claim 1, wherein the circularly-polarized optical pump beam and the linearly-polarized optical probe beam have a common optical axis, wherein the detection system (468, 486, 470) is configured to command the laser system (452, 454, 474) to provide a circularly-polarized optical pump beam pulse in response to a magnetic moment of the alkali metal vapor being approximately parallel with the common optical axis based on the detected precession of the alkali metal vapor, and is further configured to command the laser system (452, 454, 474) to provide a linearly-polarized optical probe beam pulse in response to the magnetic moment of the alkali metal vapor being approximately orthogonal with the common optical axis based on the detected precession of the alkali metal vapor to monitor the precession of the alkali metal vapor.

8. The system (450) of claim 7, wherein the detection system (468, 486, 470) is further configured to command the laser system (452, 454, 474) to provide a linearly-polarized optical probe beam pulse in response to a magnetic moment of the alkali metal vapor being each of approximately parallel with the common optical axis and approximately anti-parallel with the common optical axis based on the detected precession of the alkali metal vapor to calibrate the magnetometer system (450).

9. A method for measuring an external magnetic field via a magnetometer system (450), the method comprising:
generating a circularly-polarized optical pump beam via a pump laser (452, 474);
generating a linearly-polarized optical probe beam via a probe laser (454);
providing the circularly-polarized optical pump beam through each of a
first measurement zone (460) and a second measurement zone (462) of a sensor cell (458) comprising alkali metal vapor in a pulsed-manner based on a timing signal to facilitate precession of the alkali metal vapor in response to the external magnetic field, the first and second measurement zones (460, 462) being arranged at opposite ends of the sensor cell (458);
providing the linearly-polarized optical probe beam through the first measurement zone (460) of the sensor cell (458) in a pulsed manner based on the timing signal to provide a first detection beam corresponding to the linearly-polarized optical probe beam exiting the first measurement zone (460) of the sensor cell (458);
providing the first
detection beam to a beamsplitter (479) configured to split the first detection beam into a first portion of the first detection beam and a second portion of the first detection beam, the second portion of the first detection beam being
provided to a first optical detector (468), the first portion of the first detection beam being
provided through the second measurement zone (462) of the sensor cell (458) as a second detection beam to a second optical detector (486);
detecting the precession of the alkali metal vapor based on the first and second detection beams via the first optical detector (468) and the second optical detector (486);
generating the timing signal based on the detected precession of the alkali metal vapor via a timing controller (472); and
calculating an amplitude and direction of the external magnetic field based on the detected precession of the alkali metal vapor.

10. The method of claim 9, wherein detecting the precession of the alkali metal vapor comprises detecting the precession of the alkali metal vapor in response to the first detection beam and the second detection beam corresponding to the optical probe beam exiting the sensor cell (458) through each of the respective first and second measurement zones (460, 462).

11. The method of claim 10, wherein calculating the amplitude and direction of the external magnetic field comprises calculating a scalar magnitude of the amplitude and direction of the external magnetic field in response to the first detection beam and calculating a magnetic field gradient in response to the first and second detection beams.

12. The method of claim 10, wherein providing the linearly-polarized optical probe beam through the sensor cell (458) comprises:
providing the linearly-polarized optical probe beam through the first measurement zone (460) to generate the first detection beam; and
reflecting the first detection beam through the second measurement zone (462) via optics to generate the second detection beam, such that the second detection beam is associated with the precession of the alkali metal vapor in each of the first and second measurement zones (460, 462).

13. The method of claim 9, wherein providing the linearly-polarized optical probe beam comprises providing the linearly-polarized optical probe beam through the sensor cell (458) in response to a magnetic moment of the alkali metal vapor being each of approximately parallel with the common optical axis and after the magnetic moment of the alkali vapor has precessed approximately 180° based on the detected precession of the alkali metal vapor to calibrate the magnetometer system (450).

## Patentansprüche

1. Magnetometersystem (450), umfassend:
eine Sensorzelle (458), die Alkalimetalldampf umfasst, wobei ein erster Messbereich (460) und ein zweiter Messbereich (462) an gegenüberliegenden Enden der Sensorzelle (458) angeordnet sind, wobei der erste und der zweite Messbereich (460, 462) jeweils einem dreidimensionalen räumlichen Bereich innerhalb der Sensorzelle (458) entsprechen;
ein Lasersystem (452, 454), das eingerichtet ist, um einen zirkular polarisierten optischen Pumpstrahl in einer gepulsten Weise durch die Sensorzelle (458) hindurch bereitzustellen, um eine Präzession des Alkalimetalldampfs in dem ersten und dem zweiten Messbereich (460, 462) als Reaktion auf ein externes Magnetfeld zu erleichtern, und um einen linear polarisierten optischen Sondenstrahl basierend auf einer Präzessionsfrequenz des Alkalimetalldampfs in einer gepulsten Weise durch die Sensorzelle (458) hindurch bereitzustellen;
ein Erfassungssystem (468, 486, 470), das eingerichtet ist, um die Präzession des Alkalimetalldampfs als Reaktion auf einen ersten Erfassungsstrahl und einen zweiten Erfassungsstrahl, die dem linear polarisierten optischen Sondenstrahl entsprechen, der jeweils durch jeden der jeweiligen Messbereiche (460, 462) aus der Sensorzelle (458) austritt, zu erfassen und um eine Amplitude und eine Richtung des externen Magnetfelds basierend auf der erfassten Präzession des Alkalimetalldampfs zu berechnen, wobei das Erfassungssystem einen ersten optischen Detektor (468) und einen zweiten optischen Detektor (486) umfasst, die eingerichtet sind, um eine Präzession des Alkalimetalldampfs zu erfassen, wobei das Erfassungssystem ferner eine Taktsteuerung (472) umfasst, die eingerichtet ist, um ein Taktsignal basierend auf der erfassten Präzession des Alkalimetalldampfs zu erzeugen und um basierend auf dem Taktsignal einen Takt eines Anlegens von Impulsen, die dem zirkular polarisierten optischen Pumpstrahl zugeordnet sind, zu steuern sowie einen Takt eines Anlegens von Impulsen, die dem linear polarisierten optischen Sondenstrahl zugeordnet sind, zu steuern, um Veränderungen der Amplitude und/oder der Richtung des externen Magnetfelds zu verfolgen; und
einen Strahlteiler (479), der eingerichtet ist, um den ersten Erfassungsstrahl in einen ersten Abschnitt des ersten Erfassungsstrahls und einen zweiten Abschnitt des ersten Erfassungsstrahls zu teilen, wobei der Strahlteiler (479) ferner eingerichtet ist, um den ersten Abschnitt des ersten Erfassungsstrahls dem zweiten optischen Detektor (486) durch den zweiten Messbereich (462) hindurch bereitzustellen und um den zweiten Abschnitt des ersten Erfassungsstrahls dem ersten optischen Detektor (468) bereitzustellen.

2. System (450) nach Anspruch 1, wobei der zirkular polarisierte optische Pumpstrahl jeweils durch den ersten und den zweiten Messbereich (460, 462) hindurch bereitgestellt wird, wobei der linear polarisierte optische Sondenstrahl in der gepulsten Weise durch den ersten Messbereich (460) hindurch bereitgestellt wird, um die Amplitude und die Richtung des externen Magnetfelds zu berechnen, wobei der linear polarisierte optische Sondenstrahl jeweils durch den ersten und den zweiten Messbereich (460, 462) hindurch bereitgestellt wird, um einen Magnetfeldgradienten über die Sensorzelle zu berechnen.

3. System (450) nach Anspruch 1, wobei das Lasersystem einen 2x2-Optokoppler (456) umfasst, der eingerichtet ist, um den zirkular polarisierten optischen Pumpstrahl und den linear polarisierten optischen Sondenstrahl als eine kombinierte Strahlachse durch den ersten Messbereich (460) hindurch axial zu kombinieren, um den ersten Erfassungsstrahl basierend auf dem linear polarisierten optischen Sondenstrahl zu erzeugen, wobei der erste Erfassungsstrahl durch den zweiten Messbereich (462) hindurch reflektiert wird, um den zweiten Erfassungsstrahl zu erzeugen, sodass der zweite Erfassungsstrahl der Präzession des Alkalimetalldampfs jeweils in dem ersten und dem zweiten Messbereich (460, 462) zugeordnet ist.

4. System (450) nach Anspruch 1, wobei das Lasersystem umfasst:
einen ersten Pumplaser (452), der eingerichtet ist, um einen ersten zirkular polarisierten optischen Pumpstrahl zu erzeugen, der in einer gepulsten Weise durch den ersten Messbereich (460) hindurch bereitgestellt wird, um eine Präzession des Alkalimetalldampfs in dem ersten Messbereich (460) als Reaktion auf das externe Magnetfeld zu erleichtern; und
einen zweiten Pumplaser (474), der eingerichtet ist, um einen zweiten zirkular polarisierten optischen Pumpstrahl zu erzeugen, der durch den zweiten Messbereich (462) hindurch bereitgestellt wird, um eine Präzession des Alkalimetalldampfs in dem zweiten Messbereich (462) als Reaktion auf das externe Magnetfeld zu erleichtern.

5. System (450) nach Anspruch 4, wobei das Lasersystem ferner einen Sondenlaser (454) umfasst, der eingerichtet ist, um den linear polarisierten optischen Sondenstrahl zu erzeugen, wobei der linear polarisierte optische Sondenstrahl eingerichtet ist, um einen optischen Kalibrierungssondenstrahl gleichzeitig mit jeweils dem ersten und dem zweiten zirkular polarisierten optischen Pumpstrahl bereitzustellen, wobei das Lasersystem ferner eingerichtet ist, um den zweiten Pumpenlaser (474) als Reaktion auf eine Differenz zwischen dem ersten Erfassungsstrahl und dem zweiten Erfassungsstrahl zu kalibrieren.

6. System (450) nach Anspruch 5, wobei der linear polarisierte optische Sondenstrahl eingerichtet ist, um bei einer anfänglichen Inbetriebnahme des Magnetometersystems (450) einen Inbetriebnahmestrahl bereitzustellen, um einen anfänglichen Erfassungsstrahl bereitzustellen, wobei das Erfassungssystem (468, 486, 470) eingerichtet ist, um eine anfängliche Schätzung der Präzessionsfrequenz des Alkalimetalldampfs zu erzeugen und um eine anfängliche Amplitude und Richtung des externen Magnetfelds basierend auf der anfänglichen Schätzung der Präzessionsfrequenz zu bestimmen.

7. System (450) nach Anspruch 1, wobei der zirkular polarisierte optische Pumpstrahl und der linear polarisierte optische Sondenstrahl eine gemeinsame optische Achse aufweisen, wobei das Erfassungssystem (468, 486, 470) eingerichtet ist, um basierend auf der erfassten Präzession des Alkalimetalldampfs das Lasersystem (452, 454, 474) anzuweisen, einen Impuls eines zirkular polarisierten optischen Pumpstrahls als Reaktion darauf bereitzustellen, dass ein magnetisches Moment des Alkalimetalldampfs in etwa parallel zu der gemeinsamen optischen Achse ist, und ferner eingerichtet ist, um basierend auf der erfassten Präzession des Alkalimetalldampfs das Lasersystem (452, 454, 474) anzuweisen, einen Impuls eines linear polarisierten optischen Sondenstrahls als Reaktion darauf bereitzustellen, dass das magnetische Moment des Alkalimetalldampfs in etwa orthogonal zu der gemeinsamen optischen Achse ist, um die Präzession des Alkalimetalldampfs zu überwachen.

8. System (450) nach Anspruch 7, wobei das Erfassungssystem (468, 486, 470) ferner eingerichtet ist, um basierend auf der erfassten Präzession des Alkalimetalldampfs das Lasersystem (452, 454, 474) anzuweisen, einen Impuls eines linear polarisierten optischen Sondenstrahls als Reaktion darauf bereitzustellen, dass ein magnetisches Moment des Alkalimetalldampfs sowohl in etwa parallel zu der gemeinsamen optischen Achse als auch in etwa antiparallel zu der gemeinsamen optischen Achse ist, um das Magnetometersystem (450) zu kalibrieren.

9. Verfahren zum Messen eines externen Magnetfelds über ein Magnetometersystem (450), wobei das Verfahren umfasst:
Erzeugen eines zirkular polarisierten optischen Pumpstrahls über einen Pumpenlaser (452, 474);
Erzeugen eines linear polarisierten optischen Sondenstrahls über einen Sondenlaser (454);
Bereitstellen des zirkular polarisierten optischen Pumpstrahls in einer gepulsten Weise jeweils durch einen ersten Messbereich (460) und einen zweiten Messbereich (462) einer Sensorzelle (458), die einen Alkalimetalldampf umfasst, hindurch basierend auf einem Taktsignal, um eine Präzession des Alkalimetalldampfs als Reaktion auf das externe Magnetfeld zu erleichtern, wobei der erste und der zweite Messbereich (460, 462) an gegenüberliegenden Enden der Sensorzelle (458) angeordnet sind;
Bereitstellen des linear polarisierten optischen Sondenstrahls in einer gepulsten Weise durch den ersten Messbereich (460) der Sensorzelle (458) hindurch basierend auf dem Taktsignal, um einen ersten Erfassungsstrahl entsprechend dem linear polarisierten optischen Sondenstrahl bereitzustellen,
der aus dem ersten Messbereich (460) der Sensorzelle (458) austritt;
Bereitstellen des ersten Erfassungsstrahls an einen Strahlteiler (479), der eingerichtet ist, um den ersten Erfassungsstrahl in einen ersten Abschnitt des ersten Erfassungsstrahls und einen zweiten Abschnitt des ersten Erfassungsstrahls zu teilen, wobei der zweite Abschnitt des ersten Erfassungsstrahls an einen ersten optischen Detektor (468) bereitgestellt wird, wobei der erste Abschnitt des ersten Erfassungsstrahls durch den zweiten Messbereich (462) der Sensorzelle (458) hindurch als ein zweiter Erfassungsstrahl an einen zweiten optischen Detektor (486) bereitgestellt wird;
Erfassen der Präzession des Alkalimetalldampfs basierend auf dem ersten und dem zweiten Erfassungsstrahl über den ersten optischen Detektor (468) und den zweiten optischen Detektor (486);
Erzeugen des Taktsignals basierend auf der erfassten Präzession des Alkalimetalldampfs über eine Taktsteuerung (472); und
Berechnen einer Amplitude und einer Richtung des externen Magnetfelds basierend auf der erfassten Präzession des Alkalimetalldampfs.

10. Verfahren nach Anspruch 9, wobei das Erfassen der Präzession des Alkalimetalldampfs ein Erfassen der Präzession des Alkalimetalldampfs als Reaktion auf den ersten Erfassungsstrahl und den zweiten Erfassungsstrahl entsprechend dem optischen Sondenstrahl, der jeweils durch den ersten und den zweiten Messbereich (460, 462) hindurch aus der Sensorzelle (458) austritt, umfasst.

11. Verfahren nach Anspruch 10, wobei das Berechnen der Amplitude und der Richtung des externen Magnetfelds ein Berechnen einer Skalargröße der Amplitude und der Richtung des externen Magnetfelds als Reaktion auf den ersten Erfassungsstrahl und ein Berechnen eines Magnetfeldgradienten als Reaktion auf den ersten und den zweiten Erfassungsstrahl umfasst.

12. Verfahren nach Anspruch 10, wobei das Bereitstellen des linear polarisierten optischen Sondenstrahls durch die Sensorzelle (458) hindurch umfasst:
Bereitstellen des linear polarisierten optischen Sondenstrahls durch den ersten Messbereich (460) hindurch, um den ersten Erfassungsstrahl zu erzeugen; und
Reflektieren des ersten Erfassungsstrahls durch den zweiten Messbereich (462) hindurch über eine Optik, um den zweiten Erfassungsstrahl zu erzeugen, sodass der zweite Erfassungsstrahl der Präzession des Alkalimetalldampfs jeweils in dem ersten und dem zweiten Messbereich (460, 462) zugeordnet ist.

13. Verfahren nach Anspruch 9, wobei das Bereitstellen des linear polarisierten optischen Sondenstrahls ein Bereitstellen basierend auf der erfassten Präzession des Alkalimetalldampfs des linear polarisierten optischen Sondenstrahls durch die Sensorzelle (458) hindurch als Reaktion darauf, dass sowohl ein magnetisches Moment des Alkalimetalldampfs in etwa parallel zu der gemeinsamen optischen Achse ist als auch das magnetische Moment des Alkalidampfs in etwa um 180° präzediert hat, umfasst, um das Magnetometersystem (450) zu kalibrieren.

## Revendications

1. Système de magnétomètre (450) comprenant :
une cellule de capteur (458) comprenant de la vapeur de métal alcalin, une première zone de mesure (460) et une deuxième zone de mesure (462) agencée aux extrémités opposées de la cellule de capteur (458), chacune des première et deuxième zones de mesure (460, 462) correspondant à une région spatiale tridimensionnelle à l'intérieur de la cellule de capteur (458) ;
un système laser (452, 454) configuré pour fournir un faisceau de pompage optique à polarisation circulaire à travers la cellule de capteur (458) d'une manière pulsée pour faciliter la précession de la vapeur de métal alcalin dans les première et deuxième zones de mesure (460, 462) en réponse à un champ magnétique externe et pour fournir un faisceau de sonde optique à polarisation linéaire à travers la cellule de capteur (458) d'une manière pulsée sur la base d'une fréquence de précession de la vapeur de métal alcalin ;
un système de détection (468, 486, 470) configuré pour détecter la précession de la vapeur de métal alcalin en réponse à un premier faisceau de détection et à un deuxième faisceau de détection correspondant au faisceau de sonde optique à polarisation linéaire sortant de la cellule de capteur (458) à travers chacune des zones de mesure respectives (460, 462), respectivement, et pour calculer une amplitude et une direction du champ magnétique externe sur la base de la précession détectée de la vapeur de métal alcalin, le système de détection comprenant un premier détecteur optique (468) et un deuxième détecteur optique (486) configuré pour détecter la précession de la vapeur de métal alcalin, le système de détection comprenant en outre un contrôleur de synchronisation (472) configuré pour générer un signal de synchronisation basé sur la précession détectée de la vapeur de métal alcalin et pour commander la synchronisation de l'application d'impulsions associées au faisceau de pompage optique à polarisation circulairement et pour commander la synchronisation de l'application des impulsions associées au faisceau de sonde optique à polarisation linéaire sur la base du signal de synchronisation pour suivre les changements d'amplitude et/ou de direction du champ magnétique externe ;
un diviseur de faisceau (479) configuré pour diviser le premier faisceau de détection en une première partie du premier faisceau de détection et une deuxième partie du premier faisceau de détection, le diviseur de faisceau (479) étant en outre configuré pour fournir la première partie du premier faisceau de détection au deuxième détecteur optique (486) à travers la deuxième zone de mesure (462) et pour fournir la deuxième partie du premier faisceau de détection au premier détecteur optique (468).

2. Système (450) selon la revendication 1, dans lequel le faisceau de pompage optique à polarisation circulaire est fourni à travers chacune des première et deuxième zones de mesure (460, 462), dans lequel le faisceau de sonde optique à polarisation linéaire est fourni à travers la première zone de mesure (460) de manière pulsée pour calculer l'amplitude et la direction du champ magnétique externe, dans lequel le faisceau de sonde optique à polarisation linéaire est fourni à travers chacune des première et deuxième zones de mesure (460, 462) pour calculer un gradient de champ magnétique à travers la cellule de capteur.

3. Système (450) selon la revendication 1, dans lequel le système laser comprend un coupleur optique 2x2 (456) configuré pour combiner axialement le faisceau de pompage optique à polarisation circulaire et le faisceau de sonde optique à polarisation linéaire comme un axe de faisceau combiné à travers la première zone de mesure (460) pour générer le premier faisceau de détection sur la base du faisceau de sonde optique à polarisation linéaire, dans lequel le premier faisceau de détection est réfléchi à travers la deuxième zone de mesure (462) pour générer le deuxième faisceau de détection, de sorte que le deuxième faisceau de détection soit associé à la précession de la vapeur de métal alcalin dans chacune des première et deuxième zones de mesure (460, 462).

4. Système (450) selon la revendication I, dans lequel le système laser comprend :
un premier laser de pompage (452) configuré pour générer un premier faisceau de pompage optique à polarisation circulaire qui est fourni à travers la première zone de mesure (460) d'une manière pulsée pour faciliter la précession de la vapeur de métal alcalin dans la première zone de mesure (460) en réponse au champ magnétique externe ; et
un deuxième laser de pompage (474) configuré pour générer un deuxième faisceau de pompage optique à polarisation circulaire qui est fourni à travers la deuxième zone de mesure (462) pour faciliter la précession de la vapeur de métal alcalin dans la deuxième zone de mesure (462) en réponse au champ magnétique externe.

5. Système (450) selon la revendication 4, dans lequel le système laser comprend en outre un laser de sonde (454) configuré pour générer le faisceau de sonde optique à polarisation linéaire, dans lequel le faisceau de sonde optique à polarisation linéaire est configuré pour fournir simultanément un faisceau de sonde optique d'étalonnage conjointement à chacun des premier et deuxième faisceaux de pompage optiques à polarisation circulaire, dans lequel le système laser est en outre configuré pour étalonner le deuxième laser de pompage (474) en réponse à une différence entre le premier faisceau de détection et le deuxième faisceau de détection.

6. Système (450) selon la revendication 5, dans lequel le faisceau de sonde optique à polarisation linéaire est configuré pour fournir un faisceau de démarrage lors d'un démarrage initial du système de magnétomètre (450) pour fournir un faisceau de détection initial, dans lequel le système de détection (468, 486, 470) est configuré pour générer une estimation initiale de la fréquence de précession de la vapeur de métal alcalin et pour déterminer une amplitude et une direction initiales du champ magnétique externe sur la base de l'estimation initiale de la fréquence de précession.

7. Système (450) selon la revendication I, dans lequel le faisceau de pompage optique à polarisation circulaire et le faisceau de sonde optique à polarisation linéaire ont un axe optique commun, dans lequel le système de détection (468, 486, 470) est configuré pour commander le système laser (452, 454, 474) pour fournir une impulsion de faisceau de pompage optique à polarisation circulaire en réponse à un moment magnétique de la vapeur de métal alcalin qui est approximativement parallèle à l'axe optique commun sur la base de la précession détectée de la vapeur de métal alcalin, et est configuré en outre pour ordonner au système laser (452, 454, 474) de fournir une impulsion de faisceau de sonde optique à polarisation linéaire en réponse au moment magnétique de la vapeur de métal alcalin étant approximativement orthogonal à l'axe optique commun sur la base de la précession détectée de la vapeur de métal alcalin pour surveiller la précession de la vapeur de métal alcalin.

8. Système (450) selon la revendication 7, dans lequel le système de détection (468, 486, 470) est en outre configuré pour ordonner au système laser (452, 454, 474) de fournir une impulsion de faisceau de sonde optique polarisée linéairement en réponse à un le moment magnétique de la vapeur de métal alcalin étant chacun approximativement parallèle à l'axe optique commun et approximativement antiparallèle à l'axe optique commun sur la base de la précession détectée de la vapeur de métal alcalin pour étalonner le système de magnétomètre (450).

9. Procédé de mesure d'un champ magnétique externe via un système de magnétomètre (450), le procédé comprenant :
la génération d'un faisceau de pompage optique à polarisation circulaire via un laser de pompage (452, 474) ;
la génération d'un faisceau de sonde optique à polarisation linéaire via un laser de sonde (454) ;
la fourniture du faisceau de pompage optique à polarisation circulaire à travers chacun d'une première zone de mesure (460) et une deuxième zone de mesure (462) d'une cellule de capteur (458) comprenant de la vapeur de métal alcalin de manière pulsée sur la base d'un signal de synchronisation pour faciliter la précession de la vapeur de métal alcalin en réponse au champ magnétique externe, les première et deuxième zones de mesure (460, 462) étant agencées aux extrémités opposées de la cellule de capteur (458) ;
la fourniture du faisceau de sonde optique à polarisation linéaire à travers la première zone de mesure (460) de la cellule de capteur (458) de manière puisée , sur la base du signal de synchronisation pour fournir un faisceau de détection correspondant au faisceau de sonde optique à polarisation linéaire sortant de la première zone de mesure (460) de la cellule de capteur (458) ;
la fourniture du premier faisceau de détection Z à un diviseur de faisceau (479) configuré pour diviser le premier faisceau de détection en une première partie du premier faisceau de détection et une deuxième partie du premier faisceau de détection, la deuxième partie du premier faisceau de détection étant fournie à un premier détecteur optique (468), la première partie du premier faisceau de détection étant fournie à travers la deuxième zone de mesure (462) de la cellule de capteur (458) en tant que deuxième faisceau de détection vers un deuxième détecteur optique (486) ;
la détection de la précession de la vapeur de métal alcalin sur la base des premier et deuxième faisceaux de détection via le premier détecteur optique (468) et le deuxième détecteur optique (486) ;
la génération du signal de synchronisation sur la base de la précession détectée de la vapeur de métal alcalin via un contrôleur de synchronisation (472) ; et
le calcul d'une amplitude et une direction du champ magnétique externe sur la base de la précession détectée de la vapeur de métal alcalin.

10. Procédé selon la revendication 9, dans lequel la détection de la précession de la vapeur de métal alcalin comprend la détection de la précession de la vapeur de métal alcalin en réponse au premier faisceau de détection et au deuxième faisceau de détection correspondant au faisceau de sonde optique sortant de la cellule de capteur (458) à travers chacune des première et deuxième zones de mesure respectives (460, 462).

11. Procédé selon la revendication 10, dans lequel le calcul de l'amplitude et de la direction du champ magnétique externe comprend le calcul d'une grandeur scalaire de l'amplitude et de la direction du champ magnétique externe en réponse au premier faisceau de détection et le calcul d'un gradient de champ magnétique en réponse au premier et deuxième faisceaux de détection.

12. Procédé selon la revendication 10, dans lequel la fourniture du faisceau de sonde optique à polarisation linéaire à travers la cellule de capteur (458) comprend :
la fourniture du faisceau de sonde optique à polarisation linéaire à travers la première zone de mesure (460) pour générer le premier faisceau de détection ; et
la réflexion du premier faisceau de détection à travers la deuxième zone de mesure (462) via une optique pour générer le deuxième faisceau de détection, de telle sorte que le deuxième faisceau de détection soit associé à la précession de la vapeur de métal alcalin dans chacune des première et
deuxième zones de mesure (460, 462).

13. Procédé selon la revendication 9, dans lequel la fourniture du faisceau de sonde optique à polarisation linéaire comprend la fourniture du faisceau de sonde optique à polarisation linéaire à travers la cellule de capteur (458) en réponse à un moment magnétique de la vapeur de métal alcalin étant chacun approximativement parallèle à l'axe optique commun et après que le moment magnétique de la vapeur alcaline ait précédé d'environ 180° sur la base de la précession détectée de la vapeur alcaline pour étalonner le système de magnétomètre (450).
